(19)

Europäisches
Patentamt

European
Patent Office

Office européen
des brevets

(11) **EP 1 588 416 B1**

(12) **EUROPEAN PATENT SPECIFICATION**

(45) Date of publication and mention
of the grant of the patent:
**25.03.2009 Bulletin 2009/13**

(51) Int Cl.:
***H01L 21/762*** *(2006.01)*

(21) Application number: **04700491.6**

(86) International application number:
**PCT/IB2004/000311**

(22) Date of filing: **07.01.2004**

(87) International publication number:
**WO 2004/061944 (22.07.2004 Gazette 2004/30)**

(54) **RECYCLING OF A WAFER COMPRISING A MULTI-LAYER STRUCTURE AFTER TAKING-OFF A THIN LAYER**

RECYCLING EINES WAFERS MIT EINER MEHRSCHICHTSTRUKTUR NACH DEM ABNEHMEN EINER DÜNNEN SCHICHT

RECYCLAGE D'UNE TRANCHE COMPRENANT UNE STRUCTURE MULTICOUCHES APRES L'ENLEVEMENT D'UNE COUCHE MINCE

(84) Designated Contracting States:
**AT BE BG CH CY CZ DE DK EE ES FI FR GB GR HU IE IT LI LU MC NL PT RO SE SI SK TR**

(30) Priority: **07.01.2003 FR 0300099**
**22.05.2003 US 472435 P**

(43) Date of publication of application:
**26.10.2005 Bulletin 2005/43**

(73) Proprietor: **S.O.I.Tec Silicon on Insulator Technologies**
**38190 Bernin (FR)**

(72) Inventors:
• **GHYSELEN, Bruno**
**F-38170 Seyssinet (FR)**

• **AULNETTE, Cécile**
**F-38000 Grenoble (FR)**
• **OSTERNAUD, Bénédite**
**F-38380 Saint Laurent Du Pont (FR)**
• **AKATSU, Takeshi**
**F-38330 Saint Nazaire Les Eymes (FR)**
• **LEVAILLANT, Yves, Matthieu**
**F-38920 Crolles (FR)**

(74) Representative: **Collin, Jérôme et al**
**Cabinet Régimbeau**
**20, rue de Chazelles**
**75847 Paris Cedex 17 (FR)**

(56) References cited:
**WO-A-00/77846**          **FR-A- 2 775 121**
**US-A- 6 010 579**        **US-A1- 2001 029 072**
**US-B1- 6 426 270**       **US-B1- 6 500 732**

**Description**

FIELD OF THE INVENTION

This invention relates to the recycling of a donor wafer after having taken off a layer of a semiconductor material, the recycling including removal of substance from part of the donor wafer on the side on which taking off took place.

BACKGROUND OF THE INVENTION

Before taking off, this type of donor wafer comprises a substrate and an epitaxied layer to be taken off on the substrate.

After taking-off, the taken off layer is integrated into a structure from which components in the electronics, optic and optoelectronic fields are usually made.

Therefore, the layer to be taken off must have a high quality level determined according to one or more criteria.

The quality of the layer to be taken depends largely on the growth support, in other words the quality of the substrate on which it is epitaxied.

The formation of this type of quality substrate is often complex and requires special attention, involving technical difficulties and a high economic cost.

This point is particularly true when considering a layer to be taken off made of a composite semiconducting material such as an alloy, the epitaxy substrate in front of it also having a structure that is often difficult and expensive to make.

Thus, in particularly, this type of difficulty during manufacture occurs with a substrate comprising a buffer layer.

A "buffer layer" usually means a transition layer between a first crystalline structure, such as a support substrate, and a second crystalline structure ; the first function thereof is to modify material properties, such as the structural, stoichiometric properties or an atomic recombination at the surface.

In a special case of a buffer layer, this buffer layer makes it possible to obtain a second crystalline structure in which the lattice parameter is significantly different from the lattice parameter of the support substrate.

A first technique for making a buffer layer consists of growing successive layers so as to form a structure with a composition gradually varying in thickness, the gradual variation of the components of the buffer layer then being directly associated with a gradual variation of its lattice parameter.

A layer or a superposition of layers made on the buffer layer can be taken off from the donor wafer to be transferred to a receiving substrate, in order to make a determined structure.

One of the major applications of a transfer of thin layers formed on a buffer layer relates to the formation of elastically strained silicon layers, particularly in the case in which the silicon is strained in tension since some of its properties such as electronic mobility of the material, are then significantly improved.

Other materials, for example such as a SiGe, can also be taken off in a similar manner.

A transfer of such layers on a receiving substrate, particularly using a Smart-cut® process known to a person skilled in the art, can be used to make structures such as SeOI (Semiconductor On Insulator) structures.

For example, after taking off a layer of elastically relaxed SiGe, the structure obtained comprising the taken off layer can then be used as a support for growth of silicon that will be tensioned by the layer of relaxed SiGe.

An illustrative example of such a process is described in the IBM document by L. J. Huang et al. "SiGe-On-Insulator prepared by wafer bonding and layer transfer for high performance field-effect transistors", Applied Physics Letters, 26/02/2001, vol. 78, No. 9, in which a process for making an Si/SGOI structure is presented.

Other growth applications on a buffer layer are possible, particularly for semiconductors in the III-V family.

Transistors are thus currently made using GaAs or InP based technologies.

In term of electronic performance, InP has a significant advantage over GaAs.

The chosen technique consists of transferring a layer of InP taken off onto a receiving substrate, the InP layer being obtained by growth on a buffer layer on a GaAs support substrate, mainly due to manufacturing cost and feasibility reasons.

Some taking-off processes, such as an "etch-back" process, then cause destruction of the remaining part of the support substrate and the buffer layer when taking off.

In other taking-off processes, the support substrate is recycled but the buffer layer is lost.

The technique for making a buffer layer is complex.

Furthermore, to minimise the density of crystallographic defects, the buffer layer is usually thick, typically between one and several micrometers.

Therefore, making such a buffer layer requires a long, difficult and expensive procedure.

A second technique for making a buffer layer is presented particularly in document WO 00/15,885, and its main purpose is to elastically relax a strained Ge layer by means of a Ge buffer layer.

This technique is based on particular epitaxy conditions, particularly involving a combination of temperature, time and chemical composition parameters.

Its main advantage compared with the first technique is that it is simpler, faster and less expensive to make.

The buffer layer finally obtained is also thinner than a buffer layer made according to the first technique.

A third technique for making a buffer layer is described in the document entitled "Strain relaxation of pseudomorphic Si1-xGex / Si(100) heterostructures after hydrogen or helium ion implantation for virtual substrate fabrication" by B. Höllander et al., particularly (in Nuclear and Instruments and Methods in Physics Research B 175-177 (2001) 357-367.

It consists of relaxing the elastic strains present in the layer to be taken off by means of an in-depth nitrogen or helium implantation.

Thus, in this context, this third technique can lead to a result similar to a buffer layer made according to one of the first two techniques, but with significantly less strict application requirements.

In particularly, this process describes the relaxation of an SiGe layer strained in compression, this layer being formed on an Si substrate.

The technique used includes implantation of hydrogen or helium ions through the surface of the strained layer in the Si substrate at a determined depth, generating disturbances in the Si thickness above the implanted zone (this thickness then forms a buffer layer) and under heat treatment causes some relaxation of the SiGe layer.

This technique appears shorter, easier to implement and less expensive than the first technique for making a buffer layer.

One advantage of implementing such a technique would be that this relaxed or pseudo-relaxed layer could subsequently be integrated into a structure for making components, particularly for electronics or optoelectronics.

However, in a manner similar to the first technique for making a buffer layer, a buffer layer made according to one of the latter two techniques is eliminated according to known techniques for recycling the donor wafer after taking off is finished.

However, there are still technical difficulties in implementing it.

The document US 6 500 732 describes a cleaving process to fabricate multi layered substrates. According to this process a device layer is transferred from a donor wafer to a receiving wafer after a detachment step inside a cleaving layer.

This document only suggests to recycle the donor wafer by deleting the remaining cleaving layer and by reforming a new device or useful layer on the donor wafer before a subsequent taking-off operation.

The document FR 2 775 121 concerns a method for fabricating a thin film in a semiconductor material which consists in transferring said thin film included inside a multilayer structure from a donor substrate to a receiving one. With this process, the whole multilayer structure is transferred and thus, during the recycling step of the donor wafer, it is necessary to implant once again the donor wafer and to growth a new multilayer structure by epitaxy before to repeat the transfer step.

These two processes are costly and long to implement.

SUMMARY OF THE INVENTION

The invention provides a method of taking-off a useful layer from a donor wafer as recited in claim 1. Further embodiments are recited in claims 2-40.

The purpose of this invention according to a first aspect thereof, is to improve the situation by proposing a process of recycling donor wafer (10) after taking off a useful layer comprising as material chosen from among semiconductor materials, the donor wafers (10) comprising in sequence a substrate (1) and a multi-layer structure (I), the multi-layer structure (I) before taking-off comprising the taken-off useful layer, the process comprising a removal of substance involving a portion of the donor wafer (10) on the side where the taking-off has occurred, wherein that removal of substance is operated so as to preserve a portion of the taking-off structure (I') comprising at least one other useful layer which can be taken off after recycling, without a supplementary step of reforming the useful layer.

According to a second aspect, the invention proposes a process of making a donor wafer that will donate a useful layer by taking-off, and that can be recycled after taking off using the said method of recycling, wherein the process comprised a formation of a multilayer structure on a substrate.

According to a third aspect, the invention proposes a method of taking-off a useful layer on a donor wafer to be transferred onto a receiving substrate, comprising:

(a) bonding of the donor wafer with the receiving substrate on the side of the useful layer to be taken off;
(b) detaching the useful layer included in the multilayer structure of the donor wafer;
(c) recycling the donor wafer in accordance with the said method of recycling.

According to a fourth aspect, the invention proposes a method of cyclically taking-off a useful layer from a donor wafer, wherein comprising a sequence of steps of taking-off the useful layer, each of these steps being conform with the said taking-off process.

According to a fifth aspect, the invention proposes an application of the said cyclic taking-off process or the said taking-off process, to make a structure comprising the receiving substrate and the useful layer, the useful layer comprising at least one of the following materials: SiGe, Si, an alloy belonging to the III-V family with a composition chosen from among possible combinations of (Al, Ga, In)-(N, P, As) respectively.

According to a sixth aspect, the invention proposes a donor wafer that donates a useful layer by taking-off, and recycled or capable of being recycled by the said method of recycling, wherein it comprises in sequence a substrate, a multi-layer structure that supplied the useful layer, and after taking off, having a sufficient thickness to comprise at least one other useful layer that can be taken off.

## BRIEF DESCRIPTION OF THE FIGURES

Other aspects, purposes and advantages of this invention will become clearer after reading the following detailed description of the use of preferred processes of the invention, given as non-limitative examples with reference to the attached drawings in which :

Figure 1 shows the different steps in a process according to the invention consisting of taking off a thin layer from a donor wafer followed by recycling of the donor wafer after taking off.

Figure 2 shows a first donor wafer before taking off according to the invention.

Figure 3 shows the various steps in a process according to the invention including successively taking off a thin layer starting from a donor wafer, and recycling the donor wafer after taking off.

Figure 4 shows a second donor wafer according to the invention.

## DETAILED DESCRIPTION OF THE INVENTION

The main purpose of this invention is to recycle a wafer comprising a multi-layer structure, after taking off at least one useful layer (in other words the part of the donor wafer that was taken off) in order to integrate it into a semiconducting structure, recycling being done such that the remaining part of the multi-layer structure can once again supply a useful layer in a subsequent taking off after recycling without implementing a step to reform the useful layer, such as a step of crystalline growth by epitaxy.

Therefore, in particular recycling must include adapted treatment to not deteriorate part of the multi-layer structure in which the useful layer is included, so that this useful layer can still be taken off after recycling.

In one particular configuration, several useful layers that can be taken off may be included in the recycled multi-layer structure, so that it is thus possible to have a sequence of several successive taking off operations between which a method of recycling according to this invention can advantageously be applied.

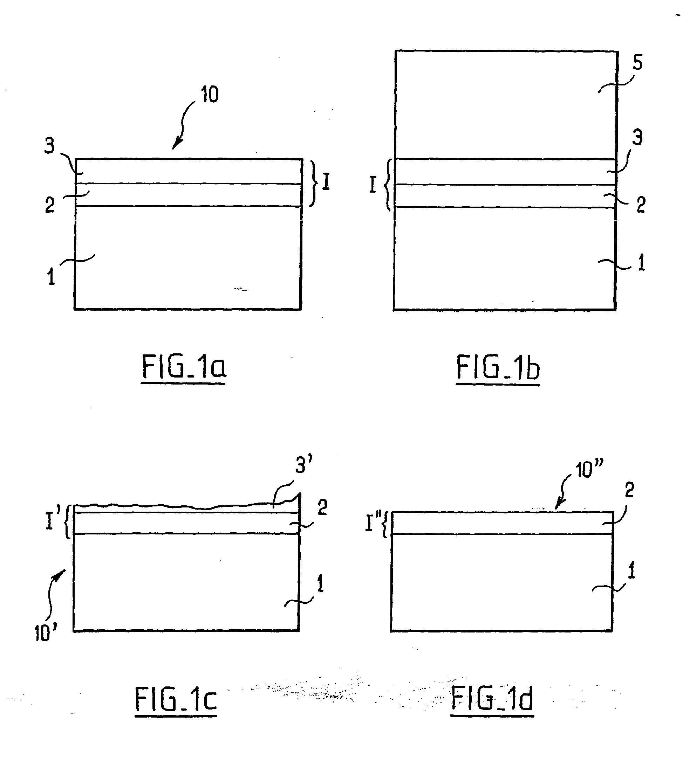

With reference to figures 1a, 1b, 2, 2a, 2b, 3 and 4, the donor wafer 10 is composed of a substrate 1 and a multi-layer structure I.

In a first configuration of the substrate 1, this substrate is composed of a single crystalline material with the first lattice parameter.

In a second configuration of the substrate 1, the substrate is a "pseudo-substrate" composed of a support substrate and a buffer structure interfaced with the multi-layer structure I.

A "buffer structure" means any structure behaving like a buffer layer.

Advantageously, the structure at the surface is a fairly relaxed crystallographic structure and / or does not have a significant number of structural defects.

Advantageously, the buffer layer performs at least one of the following two functions:

- reduction of the density of defects in the upper layer;
- adaptation of a lattice parameter between two crystallographic structures with different lattice parameters.

To perform the second function, the area around the periphery of one of the faces of the buffer layer has a first lattice parameter almost identical to the lattice parameter of the support substrate, and the area around the periphery of its other face has a second lattice parameter almost identical to the lattice parameter of the layer of the multi-layer structure I directly overlying the buffer structure).

In a first configuration of the buffer structure, the buffer structure is composed of a single buffer layer.

The buffer layer located on the support substrate has a lattice parameter on its surface significantly different from the lattice parameter of the support substrate, so that it has a layer in the same donor wafer 10 with a lattice parameter different from the lattice parameter of the support substrate.

Furthermore, in some applications, the buffer layer may prevent the overlying layer from containing a high density of defects and / or being significantly strained.

In some applications, the buffer layer may also result in a good surface condition of the overlying layer.

According to a first technique for making the buffer structure, a buffer layer is formed so as to have a lattice parameter that is globally and progressively modified over a significant thickness, to form the transition between the two lattice parameters.

This type of layer is usually called a metamorphic layer.

This modification to the lattice parameter may be made continuously within the thickness of the buffer layer.

It may be done in "stages" each stage being a thin layer with an almost constant lattice parameter different from the lattice parameter for the subjacent stage, so as to modify the lattice parameter discretely stage by stage.

It may also have a more complex form such as a variation of a variable content composition, an inversion of the sign of the variation of the content, or discontinuous steps in the composition.

The variation of the lattice parameter in the buffer layer is advantageously found by increasing the concentration in the buffer layer of at least one atomic element that is not included in the support substrate, progressively starting from the support substrate.

Thus for example, a buffer layer made on a support substrate of a unitary material may be made of a binary, ternary, quaternary or higher degree material.

Thus for example, a buffer layer made on a support substrate of a binary material may be made of a ternary, quaternary or higher degree material.

The buffer layer is advantageously made by growth on the support substrate, for example by epitaxy, using known techniques such as CVD (Chemical Vapor Deposition) and MBE (Molecular Beam Epitaxy) techniques.

In general, the buffer layer can be made by any other known method, for example in order to obtain a buffer layer composed of an alloy between different atomic elements.

A light finishing step of the surface of the support substrate subjacent to the buffer layer, for example by CMP polishing, may be performed before the buffer layer is produced.

In another configuration, the buffer layer made according to the first technique is included in a buffer structure that is composed of a buffer layer (almost identical to the first buffer layer in the first configuration) and an additional layer.

The additional layer may be between the support substrate and the buffer layer, or on the buffer layer.

In a first special case, this additional layer may form a second buffer layer, such as a buffer layer to confine defects, and thus improve the crystalline quality of the multi-layer structure I made on the buffer structure.

This additional layer is made of a semi-conducting material, preferably with a constant material composition.

The composition and thickness chosen for such an additional layer to be made are then particularly important criteria for achieving this property.

Thus, for example, structural defects in an epitaxied layer usually reduce gradually within the thickness of this layer.

In a second special case, the additional layer is located on the buffer layer and has a constant composition of relaxed material.

It can thus fix the second lattice parameter.

The additional layer may also have several functions, such as functions chosen from among these two special cases.

In one advantageous configuration, the additional layer is located on the buffer layer and has a lattice parameter significantly different from the lattice parameter of the support substrate.

In one special case of this advantageous configuration, the additional layer is a material relaxed by the buffer layer.

The additional layer is advantageously made by growth on the buffer layer, for example by epitaxy by CVD or MBE.

In a first embodiment, the growth of the additional layer is made in situ, directly in continuation with the formation of the subjacent buffer layer, the subjacent buffer layer in this case also advantageously being formed by layer growth.

In a second embodiment, the additional layer is grown after a short step for surface finishing of the subjacent buffer layer, for example by CMP polishing, heat treatment or any other smoothing technique.

A second technique for making the buffer structure is based on a technique for depositing a surface layer on a support substrate, this surface layer having a nominal lattice parameter significantly different from the lattice parameter of the adjacent material on the surface of the support substrate.

This surface layer deposit is made so that the deposited layer is almost free from plastic defects such as dislocations.

This surface layer is made so that it will eventually have:

- a first part in contact with the support substrate, that confines plastic defects such as dislocations; and
- a second part, relaxed or pseudo-relaxed by the first part, and with few or no plastic defects.

The first part of the deposited surface layer then acts as a buffer layer since:

- it confines plastic defects so as to preserve the second part of the surface layer; and
- it adapts the lattice parameter of the surface layer to match the lattice parameter of the substrate.

"Confinement" means that most plastic defects are located in the first part. The second part of the surface layer is not absolutely defect free, but the concentration of defects is compatible with microelectronics applications.

The deposition technique used to make such a buffer layer advantageously comprises variations of temperatures and chemical compositions of the deposit with time.

Thus, a buffer layer can be made with a chemical composition that is almost constant through the thickness, unlike a buffer layer made according to the first technique.

However, one or several layers may be inserted between the buffer layer and the second part of the surface layer.

Furthermore, the thickness of the buffer layer may be less than the minimum thicknesses of buffer layers made according to the first technique.

Document WO 00/15885 provides information about an example embodiment of such a buffer layer according to this technique, by making a deposit of SiGe or Ge on a monocrystalline Si support substrate.

For example, this type of deposition process may be made in a mode in which a deposit of monocrystalline Ge is made on a monocrystalline Si support substrate, according to the following steps:

- temperature stabilisation of the monocrystalline silicon *support substrate* at a first predetermined stabilised temperature between 400°C and 500°C, and preferably between 430°C and 460°C;
- chemical vapour deposition (CVD) of Ge at the said first determined temperature until a *base layer* of Ge is obtained on the support substrate with a predetermined thickness less than a required final thickness;
- increase in the temperature of the chemical vapour deposition of Ge from the first predetermined temperature up to a second predetermined temperature between 750°C and 850°C and preferably between 800°C and 850°C; and
- continuation of the chemical vapour deposition of Ge at the said second predetermined temperature until the final required thickness is obtained for the surface layer of monocrystalline Ge.

The buffer layer is the part of the deposited layer that interfaces with the support substrate and that extends over a thickness in which the crystallographic defects ratio is greater than a limiting value.

In particular, the thickness of this buffer layer may be of the order of 0.5 to 1 micron, which is less than the thickness of a buffer layer made according to the first technique.

The other part of the layer is at least part of the multi-layer structure I.

This type of deposition process may also be made with different variant - for example as described in document WO 00/15885.

The result is production of the substrate 1 of the donor wafer 10, the substrate 1 comprising the said support substrate and the said buffer layer.

A third technique for making a buffer structure is used on a structure comprising the substrate 1 and a layer deposited on the substrate 1.

The material chosen to form this layer is a material with a nominal lattice parameter significantly different from the lattice parameter of the surface of substrate 1, so that it has to be elastically strained in compression or tension by substrate 1.

The general structure of the strained layer is made of a strained material, but it may also contain one or several thicknesses of relaxed or pseudo-relaxed material for which the accumulated thickness is very much less than the thickness of the strained layer, so that the strained layer remains in a globally strained state.

In all cases, the strained layer is advantageously formed on substrate 1 by crystalline growth such as by epitaxy, and using known techniques for example such as the CVD or MBE techniques.

In order to obtain such a strained layer without too many crystallographic defects, for example such as isolated defects or extensive defects such as dislocations, it is advantageous to choose crystalline materials forming the substrate 1 and the strained layer (close to its interface with substrate 1) so that the difference between their first and second nominal lattice parameters is sufficiently small.

For example, this difference in the lattice parameter is typically between about 0.5% and about 1.5%, but it could be higher.

For example, in IV-IV materials, the nominal lattice parameter of Ge is greater than the lattice parameter of Si by about 4.2%, and therefore SiGe with 30% of Ge has a nominal lattice parameter greater than the lattice parameter of Si by about 1.15%.

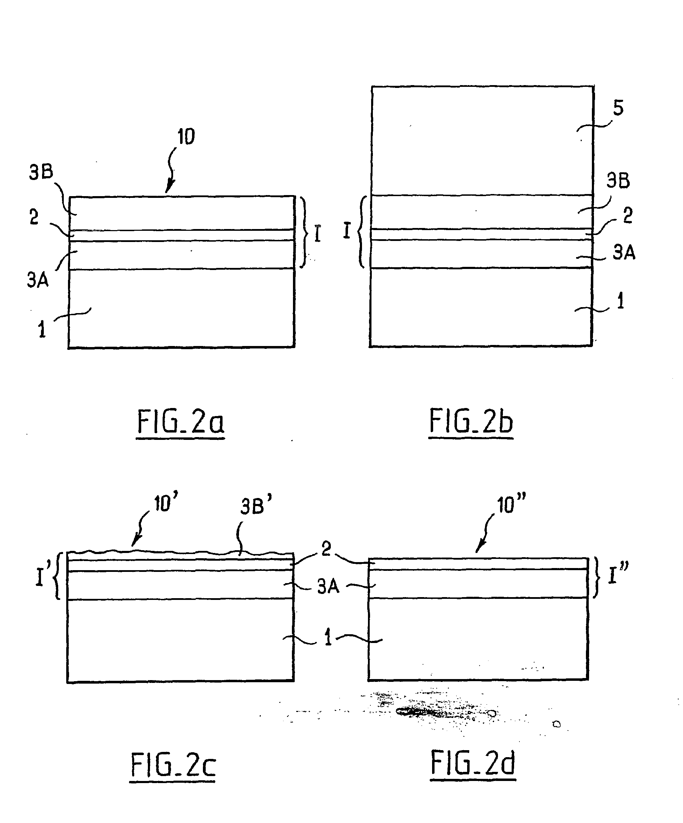

Furthermore, it is preferable if the thickness of the strained layer is almost constant, so that it can have almost constant intrinsic properties and / or to facilitate future bonding with the receiving substrate (as shown in figure 1b or 2b).

To prevent relaxation of the strained layer or the appearance of plastic type internal stresses, the thickness of the strained layer must also remain less than a *critical elastic strain thickness*.

This critical elastic strain thickness depends mainly on the material chosen to form the strained layer and the said difference in the lattice parameter with the substrate 1.

Those skilled in the art will use information known in the state of the art to determine the value of the critical elastic strain thickness of the material that they use for the strained layer formed on the material used for the substrate 1.

Therefore, once the strained layer is formed, it has a lattice parameter approximately the same as the lattice parameter of its growth substrate 1, and is then subjected to internal elastic compression or tension strains.

Once the structure is formed, the third technique for making a buffer structure comprises a first step for the formation of a disturbance zone at a given depth in the substrate 1.

A disturbance zone is defined as a zone in which internal stresses exist that can form structural disturbances in surrounding parts.

This disturbance zone is advantageously formed over most of the surface of the substrate 1 parallel to the surface of the substrate 1.

One method for forming such an embrittlement zone comprises an implantation of atomic species in the substrate 1 at a given determined depth, with a determined implantation energy and determined proportioning of atomic species.

In a particular embodiment of the implantation, the implanted atomic species comprise hydrogen and / or helium.

This type of disturbance zone formed by implantation then comprises internal strains, or even crystallographic defects, exerted by the atomic species implanted on the crystalline network adjacent to the disturbance zone.

These internal strains can then create crystallographic disturbances in the overlying zone.

According to this third technique, the buffer layer is made while a second step is being carried out by an energy input adapted to and with appropriate parameters to:

- help with the appearance of disturbances in the region overlying the disturbance zone;
- increase the amplitude of these disturbances in this overlying region; and
- cause an elastic relaxation at least in the strained layer following the appearance of disturbances.

Therefore the main purpose of such an energy input is to cause at least relative relaxation of the elastic strains in the strained layer in order to form a *relaxed strained layer*.

The intermediate region within substrate 1 between the disturbance zone and the strained layer:

- confines dislocation type defects;
- adapts the lattice parameter of the substrate 1 to the nominal lattice parameter of the strained layer;

Therefore, in this case this intermediate region can be considered as being a *buffer layer*.

A heat treatment is advantageously used, if suitable parameters are defined for it, to generate the said sufficient energy input to cause these structural modifications.

This heat treatment is advantageously carried out at temperatures significantly lower than a critical temperature above which a significant number of implanted atomic species would be degassed.

Thus, local crystallographic disturbances are created from these internal strains in the disturbance zone.

These disturbances appear mainly in the buffer layer, particularly due to minimisation of elastic energy in the strained layer, and they increase in amplitude under the influence of the heat treatment.

When these disturbances have become sufficiently large, they act on the strained layer by relaxing the elastic stresses in the strained layer at least in relative terms, these relaxed strains mainly being due to the mismatch in the lattice parameters for the nominal mesh in the material in the strained layer and the material in substrate 1.

However, relaxation of the strained layer can also be accompanied by the appearance of inelastic type crystalline defects in the thickness of the strained layer, such as through dislocations.

Suitable treatments such as a heat treatment, can then be applied to reduce the number of these defects.

For example, an adapted treatment can be used to increase the density of dislocations to bring it between two limiting values, the two limiting values defining an interval of dislocation densities in which at least some of the dislocations cancel themselves out.

In all cases, the end result is a relaxed or pseudo-relaxed layer for which the nominal lattice parameter is significantly different from the nominal lattice parameter of the growth substrate 1 and which has a low content of dislocations disadvantageous for the formation of microelectronic components in the relaxed strained layer.

This relaxed or pseudo-relaxed layer may form at least part of the multi-layer structure I.

For more information, refer to B. Höllander et al., particularly in the document entitled "Strain relaxation of pseudomorphic Si1-xGex / Si(100) heterostructures after hydrogen or helium ion implantation for virtual substrate fabrication" (Nuclear and Instruments and Methods in Physics Research B 175-177 (2001) 357-367).

The buffer layer thus made using this third technique for making the buffer layer is included in substrate 1 as defined before use of this third technique for making the buffer layer.

A fourth technique for making the buffer structure is based on a support substrate for the buffer structure to be made, for which the surface is in relief; and deposition of the component elements of the buffer structure on the support substrate.

Since the surface of the support substrate is not plane, the deposition of the components of the buffer structure is made anisotropically with growth selectivity effects and local coalescence that result in the constructed buffer structure with determined properties.

This fourth method of making the buffer structure uses determined techniques with parameters set such that the properties obtained in the buffer layer correspond to crystallographic defect confinement properties, so that the taking off structure I that will be made on the buffer structure has an intrinsic quality structure.

The choice of the topography of the support substrate is one of the essential factors for obtaining such a result.

Preferably, a topography with patterns will be chosen that is periodically repeated over the entire surface of the support substrate, in order to have a homogeneous influence over the entire surface of the wafer.

For example, there would be a support substrate with bands at a fixed distance from each other.

For this type of topography in bands, and under some deposition conditions, it is possible to successfully concentrate dislocations of epitaxied layers close to the bands, and particularly the corners of the bands.

The thickness of the layer in which most of the dislocations are confined then forms the *buffer layer*.

For this particular surface topography of the support substrate in bands at a periodic spacing over the entire surface of the support substrate, the bands are advantageously composed of an insulating material formed on a substrate and thus forming a mask to materials that will be deposited later.

Furthermore, an intermediate layer of crystalline materials can be inserted between a solid substrate and the structure in relief, acting as a substrate for growth of the buffer structure, the insulating structure in relief then being sufficiently thin so that it does not disturb resumed growth of the buffer structure on the growth substrate subjacent to it.

This technique is also called ELOG (Epitaxially Laterally Overgrown) and is applied mainly to deposits of nitride films by MOCVD (Metal Organic-Chemical-Vapor-Deposition) epitaxy.

For example, the article by Shuji Nakamura entitled "InGaN/GaN/AlGaN-Based Laser Diodes with an Estimated Lifetime of Longer than 10 000 hours" in the "Materials Research Community" Bulletin, May 1998, volume 23, No. 5, can be used as a basis, which in particular describes growth of GaN on a structure of $SiO_2$ bands.

Example 9 given later in the document will describe a GaN structure made using this fourth technique for making the buffer structure by ELOG.

Regardless of the structural configuration in substrate 1 (which may or may not comprise a buffer structure), the substrate 1 is formed from a crystalline material at the interface with the multi-layer structure I, with few or no crystallographic defects.

At least some of the different layers forming the multi-layer structure I are advantageously made by growth on substrate 1, for example by epitaxy by CVD or MBE.

In a first embodiment, at least some of these layers are grown in situ, directly in continuation with the formation of the layers subjacent to each layer, the subjacent layers in this case also advantageously being formed by layer growth.

In a second embodiment, at least some of these layers are grown after steps to apply light surface finishes to the layers subjacent to each layer, for example by CMP polishing, heat treatment or other smoothing technique.

Finally, a multi-layer structure I is obtained comprising layers of crystalline materials.

The multi-layer structure I before recycling comprises a thickness equivalent to or greater than at least two useful layers.

However, the multi-layer structure I is advantageously thicker than two useful layers to compensate for material thicknesses removed during treatment(s) applied during recycling to correct defects usually created when the useful layer is taken off.

Roughnesses, thickness variations, structural defects and / or other types of defects are frequently found on the surface of a donor wafer 10 after taking off, like that shown in the post-taking off layer 3' with reference to figure 1c or figure 2c.

For example, projecting and / or rough parts may appear on the taking off surface of the remaining donor water 10, after taking off.

These surface parts in relief that appeared on the surface of the multilayer structure I depend mainly on the manner of taking off and the technique used during taking off.

- Thus, for example, one manner of taking off frequently used in industry consists of taking off the useful layer over only part of the donor wafer 10 (which is usually approximately the centre part) and leaving projecting parts over the surface of the donor wafer 10, rather than over the entire surface of the donor wafer 10. These projecting parts are generally single-piece and located around the periphery of the surface of the donor wafer 10, all projecting parts then being called a "taking off ring" in the business".

- Thus for example, known taking off techniques, for example like those that we will describe in more detail later in this document, such as the Smart-Cut technique mentioned above, will sometimes cause surface roughness.

Therefore the thickness of the multilayer structure I before taking off must be at least two useful layers to be taken off and a thickness greater than or equal to a thickness margin corresponding to the minimum amount of material to be removed during the recycling operation(s).

This thickness margin is thus typically of the order of one micron in the case of recycling after a Smart-Cut type of taking off (which will be discussed later).

However, this thickness margin can be reduced by using high performance recycling techniques such as selective chemical etching.

One main type of processing applied during recycling according to the invention is a process for removing material adapted so that only part of the multi-layer structure I is kept, comprising at least one other useful layer that can be taken off after recycling.

This or these substance removal(s) is (are) applied on the donor wafer 10, in other words at the free surface of the multi-layer structure I that remains after taking off.

In one particular method of recycling, a surface treatment is applied to remove part of the multi-layer structure I on which the useful layer was taken off.

In particular, this removal of surface material removes a surface thickness containing surface defects that appeared during taking off, such as dislocation type crystallographic disturbances or isolated defects.

Several surface treatments such as the following can thus be applied individually or in combination:

- dry or wet chemical etching, advantageously applied in a bath, by plasma or by atomisation; etching may be chemical, electrochemical or photo-electrochemical alone, or any other equivalent etching such as etching applied during mechanical-chemical polishing;
- annealing, for example under hydrogen;
- chemical etching, for example under HCl accompanied by annealing;

- a surface oxidation step, carried out using oxidation techniques known to a person skilled in the art, on the surface of the multi-layer structure I, followed by a step to remove the oxidised layer by deoxidation, advantageously using a chemical process (such as attack by a hydrofluoric acid bath) advantageously preceded by an annealing step. This type of sacrificial oxidation process will be described later in this document.

A surface treatment may also significantly improve the surface condition of the multi-layer structure I remaining after taking off, and also the uniformity of its thickness, particularly in the case of the last four surface treatments, and this is particularly useful if bonding is applied when the useful layer is taken off.

Regardless of the surface treatment(s) selected to be used, they can improve the surface quality of the multi-layer structure I compared with the surface condition before this treatment was applied.

In a first case, the improvement in the structural and geometric quality of the multi-layer structure I is sufficiently good so that a useful layer can be taken off without any additional substance removal treatments.

In this first case, and in a first configuration of the multi-layer structure I before taking off, the multi-layer structure is composed of several layers of the same material with almost the same properties.

In this first case and in a second configuration of the multi-layer structure I before taking off, this multi-layer structure comprises several layers, for example as shown in figure 1a, 2a, 3 or 4, with material properties significantly different from each other at each of their interfaces.

Regardless of the configuration of the multi-layer structure I, after taking off, material is removed from the surface over a given thickness so that finally there will be one or several layer(s) remaining comprising one or several useful layer(s) that can be taken off in a subsequent taking off operation.

In a second case, the improvement in the structural and geometric quality of the multi-layer structure I obtained after use of the surface treatment is not sufficient for a useful layer to be taken off without other subsequent substance removal treatments.

The additional treatments to be applied after these surface treatments then advantageously include selective removal of one layer with regard to the adjacent layer, the selectivity between the two layers being due essentially to significant differences in the properties of the two materials making up these two layers.

Selective substance removal may also follow another substance removal different from that obtained after a surface treatment, for example such as more massive removal of substance in part of the multi-layer structure I, for example such as mechanical removal by grinding, polishing, abrasion and / or by bombardment.

However, a treatment for selective substance removal may also be applied without necessarily applying prior treatments such as surface treatments or more massive substance removals.

In order to apply such a selective substance removal, before taking off, the multi-layer structure I comprises a layer that stops removal of the material in the overlying layer, in other words the two materials that make up the two layers close to their interface are chosen such that there is a means of selectively removing material, in other words with a capacity for attacking the layer to be removed significantly greater than the capacity for attacking the stop layer.

Taking off then applies to the part of the multi-layer structure I above the stop layer, in other words on the side of the stop layer opposite the substrate 1.

Several techniques for the selective removal of substance may be used for the protection layer 3.

A first technique for the selective removal of substance consists of exerting friction forces on the layer to be selectively removed, to pull off at least part of the material to be removed.

For example, these friction forces may be exerted by a polishing plate, possibly combined with an abrasive action and / or a chemical action.

The material that forms the stop layer is chosen from semiconductors so that there is a mechanical means of attacking the material with a significantly lower capacity to mechanically attack the material forming the stop layer than the capacity to attack the material in the overlying layer to be removed, and thus being suitable for the use of at least one selective mechanical attack.

The material in the stop layer then has significantly greater resistance to the mechanical attack used than the layer overlying it.

Consequently, for example it would be possible to suitably harden the protection layer 3 to make it more resistant than the overlying layer to the mechanical attack selected to remove the overlying area.

Thus for example, it is known that a semiconductor such as Si, carbonated with a concentration of C typically between 5% and 50%, is harder than the same non-carbonated semiconductor.

A second technique for selective removal of substance consists of chemically and selectively etching the material to be removed.

A wet etching process may be used with etching solutions adapted to the materials to be removed.

A dry etching process may also be used to remove material, such as etching by plasma or by atomisation).

Etching may also be only chemical, electrochemical, or photo-electrochemical.

The material from which the stop layer is made is chosen from among semiconductors so that there is a fluid (in other words a gas or a solution depending on whether the etching is dry or wet) for etching with a significantly lower capacity to etch the material forming the stop layer than the material in the overlying layer to be removed, and thus being capable of implementing selective etching.

However, note that the term "stop layer" has a primary function of "stopping" etching, even if there is no absolute stopping of etching. This is particularly the case for etching by atomisation, for which we talk more accurately about "atomisation rate" or "attack rate".

In general, the selectivity of etching a layer A with respect to a layer B is quantified by a selectivity factor related to the ratio

$$\frac{\textit{Etching rate for layer A}}{\textit{Etching rate for layer B}}$$

The stop layer thus acts as a barrier to chemical attack, by protecting itself and the part subjacent to it (which includes substrate 1).

The selectivity of chemical etching between the material in the stop layer and the material in the layer to be removed concerned by selective etching may be obtained by the fact that:

- the two materials are different; or
- the two materials contain almost identical atomic elements, except for at least one atomic element; or
- the two materials are almost identical, but the atomic concentration of at least one atomic element in a material is significantly different from the atomic concentration of the same atomic element in the other material; or
- the two materials have different porosity densities.

For example, it is known that SiGe behaves like a stop layer with regard to etching of Si with a solution containing compounds such as KOH (potassium hydroxide, selectivity about 1:100), $NH_4OH$ (ammonium hydroxide, selectivity about 1:100) or TMAH (tetramethyl ammonium hydroxide).

For example, it is known that SiGe with a concentration of germanium greater than or equal to 25% behaves like a stop layer with regard to etching of SiGe with a germanium concentration less than or equal to 20%, with a solution containing compounds such as TMAH.

For example, it is known that Si suitably doped with a selected doping element and a selected concentration, such as boron at more than $2 \times 10^{19}$ cm$^{-3}$, behaves like a stop layer for etching an Si material not doped with a solution containing compounds such as EDP (ethylene diamine and pyrocathechol), KOH or $N_2H_2$ (hydrazine).

For example, it is known that porous Si is etched using an etching that is selective with regard to non-porous crystalline Si, using a solution containing compounds such as KOH or HF + $H_2O_2$.

This chemical removal of substance may also be accompanied by the use of mechanical or other means for attacking the material.

In particular, CMP polishing may be used with a selective chemical etching solution.

A selective chemical etching may also be preceded or followed by removal of substance made by mechanical means of attacking the material such as polishing, grinding, abrasion or any other means.

A third technique for selective removal of substance consists of applying sacrificial oxidation.

In this respect, the multi-layer structure I comprises an oxidisable layer with a greater oxidation capacity than the subjacent layer, and that will be the layer to be removed selectively with respect to the subjacent layer to be kept that thus acts as the stop layer.

The oxidisable layer is included within the multi-layer structure I before taking off (and therefore before recycling), and the taking off then applies to the part of the multi-layer structure I located above the oxidisable layer, in other words on the side of the stop layer opposite the substrate 1.

The oxidisable layer is oxidised after taking off at the surface of the multi-layer structure I at the time of recycling, and then corresponds to a treatment technique for the removal of surface material described above.

Regardless of the selected configuration, the sacrificial oxidation process comprises a step for formation of an oxide layer, possibly an annealing step, and a deoxidation step.

Oxidation may apply to the oxidation of one or several layers.

Oxidation may also be done close to the surface of the stop layer.

Oxidation is done using any of the known oxidation techniques, such as thermal oxidation.

In the special case in which thermal oxidation is used, the main parameters are the oxidation temperature and duration.

Other important parameters are the oxidising nature of the atmosphere, the oxygen content and treatment pressure conditions.

These parameters may be well controlled, which means that the reproducibility of this application of the process is good.

The purpose of the annealing step is to cure defects that might occur during the previous oxidation step.

The deoxidation step consists of removing the oxide layer selectively with respect to the stop layer, for example by a chemical process using a hydrofluoric acid bath, and forms the said selective substance removal.

For illustration purposes, oxidised silicon dipped in a 10 or 20% hydrofluoric acid bath for a few minutes can typically remove one hundred to several hundred nanometers of thickness of this oxide.

Regardless of the method(s) used for selective removal of substance in the process according to the invention, in all cases they can maintain a quality of the layers of the multi-layer structure I remaining after recycling almost identical to the quality that they had before recycling, and similar to the original quality during their formation (before the first taking off) such as a layer with a quality similar to the quality of the epitaxied layer.

The removable layer(s) remaining present in the multi-layer structure I after recycling according to the invention thus keep a very good quality, and particularly a structural quality.

Examples of selective removals of material applied during recycling, taking off processes that can be used, and donor wafers before recycling are given in the rest of this document.

With reference to figure 1a, the multi-layer structure I before taking off is composed of a first layer 2 and a second layer 3 on the first layer 2, the first layer 2 forming a stop layer for selective removal of the second layer 3.

Layer 2 and layer 3 are each thicker than or the same thickness as the useful layer.

A method for taking off a thin layer is shown in figures 1b and 1c.

A first preferred take off step according to the invention consists of creating an embrittlement area in the second layer 3, in order to perform a detachment and thus take off the required layer(s).

Several techniques may be used to create an embrittlement area of this type, as presented herein:

A first technique, called the Smart-cut ® technique, known to those skilled in the art (and that is described in a number of books dealing with techniques for reducing wafers) contains a first step in which atomic species (such as hydrogen ions) are implanted with a determined energy to thus create an embrittlement area.

A second technique consists of forming a weakened interface by creation of at least one porous layer, for example as described in document EP-A-0 849 788.

The weakened area advantageously formed according to one of these two techniques, in this example following the process according to invention, is created between the first layer 2 and the second layer 3 or in the second layer 3.

With reference to figure 1b, a second step concerning taking off a thin layer consists of adding on a receiving substrate 5 to the surface of the donor wafer 10.

The receiving substrate 5 forms a sufficiently rigid mechanical support to support the second layer 3, part of which will be taken off from the donor wafer 10, and to protect it from any mechanical stresses from the outside.

This receiving substrate 5 may for example be made of silicon or quartz or any other type of material.

The receiving substrate 5 is added on by bringing it into intimate contact with the multi-layer structure I and bonding it, in which there is advantageously a molecular bonding between the substrate 5 and structure 1.

This bonding technique, and variants of it, are described particularly in the document entitled "Semiconductor Wafer Bonding" (Science and technology, Interscience Technology) by Q.Y. Tong, U. Gösele and Wiley.

If necessary, bonding is accompanied by an appropriate treatment of the corresponding surfaces to be bonded initially and / or by inputting thermal energy and / or by adding an additional binder.

Thus for example, a heat treatment used during or immediately after bonding makes the bond rigid.

Bonding may also be controlled by a bonding layer such as silica, inserted between the multi-layer structure I and the receiving substrate 5, with particularly strong molecular bonding capacities.

Advantageously, the material forming the bonding face of the receiving substrate 5 and / or the material of the bonding layer formed if any, is electrically insulating to make an SeOI structure from the taken off layers, the semiconducting layer of the SeOI structure in this case being the taken off part of the second transferred layer 3.

Once the receiving substrate 5 is bonded, the part of the donor wafer 10 is removed at the weakened area formed previously, by detaching it.

In the case of the said first technique (Smart-cut®), a second step is carried out in which the area implanted (forming the embrittlement area) is subjected to a thermal and / or mechanical treatment, or a treatment with any other type of energy input, to detach it at the embrittlement area.

In the case of the said second technique, the weakened area is mechanically treated, or another type of energy is input, in order to detach it at the weakened layer.

Detachment at the embrittlement area according to one of these two techniques removes the largest part of the wafer 10, to obtain a structure comprising whatever is left, if any, of the part of the second layer 3 that was taken off (which in this case represents the useful layer), the bonding layer if any and the receiving substrate 5.

A finishing step on the surface of the structure formed at the taken off layer is advantageously applied to remove any surface roughness, non-homogeneities in the thickness and / or undesirable layers, for example using a chemical mechanical polishing CMP, an etching or at least one heat treatment.

In one particular configuration, a stop layer with a selective removal of substance may be included in the useful layer in order to improve the finish of the useful layer by selective removal of substance stopped at this stop layer.

A post-taking off layer 3' forms the part of the second layer 3 that remained after taking off and located above the first layer 2, the complete wafer forming a donor wafer 10' to be sent to recycling so that it can be reused later during taking off a subsequent layer.

The result of recycling such a donor wafer 10' is shown in figure 1d.

It uses selective removal of substance in the post-taking off layer 3' with respect to the first layer 2, possibly followed by or preceded by a surface finishing step.

The donor wafer 10'' is then capable of providing a useful layer taken off in the first layer 2 during a subsequent taking off without any additional step.

In another configuration of the donor wafer 10 before taking off, the donor wafer comprises several pairs, each composed of the said first layer 2 and second layer 3, the second layer of each pair can be removed selectively with respect to the first layer in the same pair by a means capable of selectively removing the material.

Advantageously, there is also a means of removing material in a layer 2 of a pair selectively with respect to the layer subjacent to it, and that is also included within the multi-layer structure I.

This configuration has the advantage that the layer 3 can be removed selectively with respect to the subjacent layer 2 or the layer 2 can be removed selectively with respect to the layer subjacent to it.

Still, in this configuration and in one special case, the layer subjacent to layer 2 is a layer 3 that belongs to another pair of layers.

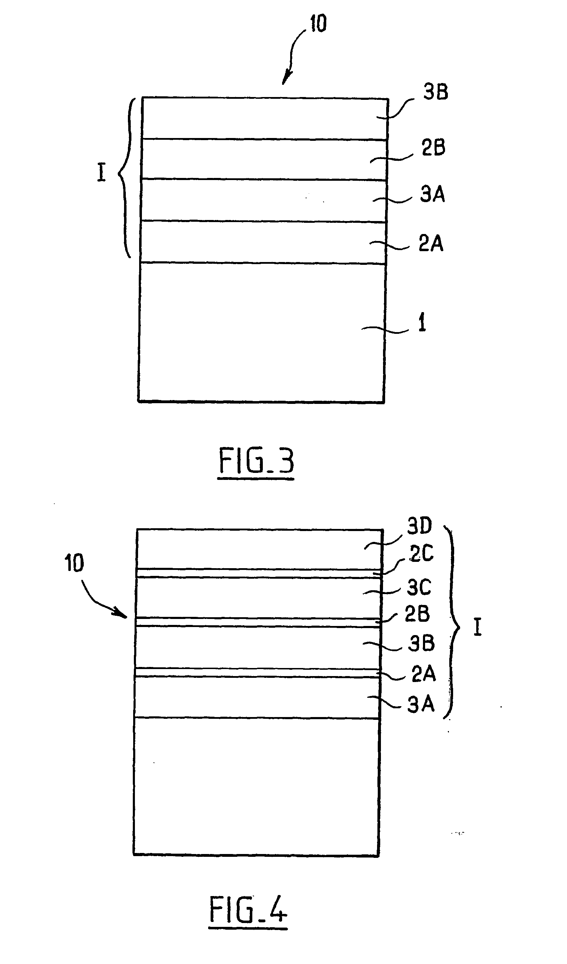

One example of a particular configuration of a multi-layer structure I comprising several such pairs of layers is given with reference to figure 3, in which the multi-layer structure I is composed of a first pair consisting of a first layer 2A and a second layer 3A and a second pair consisting of a first layer 2B and a second layer 3B, each layer having the same thickness or a greater thickness than the useful layer.

In this configuration of a donor wafer 10, one or several layers can be removed in one or several steps, according to one process according to the invention, with one or more intermediate recycling steps according to the invention being applied by selective removal of substance in the part of the layer remaining after taking off and the subjacent layer comprising at least one useful layer that can be taken off.

Thus, with this particular configuration it is possible to take off useful layers with one or several layers of materials.

With reference to figure 2a, the multi-layer structure I in this case is composed of a first layer 2 inserted between a second layer 3B overlying it and a third layer 3A adjacent to the substrate 1, before taking off.

The thicknesses of the second layer 3B and the third layer 3A are greater than or equal to the thickness of the useful layer.

The material in the first layer 2 is chosen such that there is at least one means of removing material with a capacity to attack the material forming the first layer 2 significantly different from the capacity to attack the material in at least one of the two layers 3A and 3B, at their corresponding interfaces.

And it can thus implement selective substance removal.

In a first configuration, the thickness of the first layer 2 is equal to or greater than the thickness of a useful layer to be taken off.

The result is then a configuration equivalent to one of those already described above.

In a second configuration, the crystallographic structure of layers 3A and 3B, and particularly the lattice parameters, are almost identical, and we would then not want the first layer 2 to significantly disturb the crystallographic structure of its adjacent layers 3A and 3B, and particularly we would not want it to disturb the crystalline growth of the second overlying 3B during its formation on the first layer 2, for which in this case the lattice parameter must be approximately the same as the lattice parameter for the part 3A subjacent to the first layer 2.

This result is achieved using one or several embodiments of the first layer 2, among those described below:

In a first embodiment of the first layer 2, this first layer is elastically constrained so that its lattice parameter is almost identical to the lattice parameter of area 3A subjacent to it, even if the lattice parameter of the material in this layer is significantly different from the lattice parameter of the first layer 2.

Two main conditions then have to be respected in order to carry out this operation successfully:

- the nominal parameter of the first layer 2 and the lattice parameter of the zone subjacent to it (included within the third layer 3A) are not too different from each other, to prevent the appearance of defects (such as dislocations or local stresses) in the first layer 2;

- the first layer 2 must be sufficiently thin to prevent progressive relaxation of the elastic strain through the thickness of the layer and / or the generation of defects. To achieve this, the thickness of such a first layer 2 made of an elastically strained semiconducting material must be less than a critical thickness known to a person skilled in the art, and depending particularly on its component materials, of the materials in the layers adjacent to it, and techniques for making the strained layer.

Critical thicknesses typically encountered for an Si layer 2 between two layers 3 A and 3 B of SiGe (50% - 50%) are approximately equal to a few tens of nanometers.

In a second embodiment of the first layer 2, a material is chosen for the first layer 2 with a nominal lattice parameter almost the same as the lattice parameter of the materials from which the zones adjacent to it are made.

Thus, unlike the first embodiment, the crystallographic structure of the first layer 2 in this case is significantly relaxed.

Consequently, and also to satisfy a selectivity criterion during removal of substance applied during the first recycling step, for example the material for the first layer 2 will be chosen such that it has at least one constituent element that is not in at least one of the materials adjacent to it, however the material in the first layer 2 having a lattice parameter similar to the lattice parameter of adjacent zones, this constituent element is then the essential element that will determine selectivity with respect to the adjacent layer considered during selective removal of substance.

In one special case, no constituent element of the material in the first layer 2 is present in the material making up the adjacent zone concerned by selective removal of substance, and the two materials are then entirely different.

In the other special case, every constituent element in the first layer 2 that is different from the adjacent zone concerned by selective removal of substance may be an additional element or an element that does not exist in the adjacent layer being considered.

For example, a first layer 2 with approximately the same lattice parameter as adjacent zones could be doped, so that this lattice parameter is not significantly disturbed after doping.

If the first layer 2 is composed of the same material as the material from which the adjacent zone concerned by the selective removal of substance is made, this doping element is the element that will then determine the selectivity capacity.

When doping the first layer 2, the thickness of the first layer 2 may in some cases remain less than a critical thickness known to those skilled in the art, if defects such as dislocations, and particularly through dislocations, are not wanted.

In a third embodiment of the first layer 2, the layer 3A made previously is made porous on the surface in order to make a porous layer.

This increase in porosity may be applied by anodisation or by any other porosity technique, for example like that described in document EP 0 849 788 A2.

This layer of porous material may make a first layer 2, if at least one adjacent material can be selectively attacked using an appropriate attack method.

The porosity does not significantly disturb the crystallographic structure of these two adjacent layers, therefore such a first layer 2 does not significantly disturb the crystallographic structure of the donor wafer 10.

The result is a crystallographic structure of the first layer 2 that is very similar if not identical to the crystallographic structure of the zones adjacent to it, therefore the first layer 2 does not disturb the crystallography of the surrounding structure.

However, in other cases, there may be a first layer 2 with a specific influence on the lattice parameter of the surrounding structures, the state (strained or relaxed, complete or relative) that the first layer 2 may induce in adjacent layers, in these cases represents a property considered as having very little advantage for the following application.

With reference to figures 2b and 2c, part of the layer 3B is taken off to transfer it onto a receiving substrate 5 according to a taking off method almost identical to those described above with reference to figures 1b and 1c.

After taking off and during recycling, selective removal of substance applied at the first layer 2 consists of at least one of the following selective removals of material:

- with reference to figure 2d, selective removal of the material in the layer 3B' adjacent to the first layer 2, the first layer 2 forming a stop layer for removal of substance;
- after removal of layer 3B', selective removal of the material in the first layer 2, the material in the third layer 3A adjacent to the first layer 2 forming a stop layer for removal of substance.

In one particular method of selective removal, it is thus possible to combine two successive selective removals of materials at the first layer 2.

In this case, the second layer 3B, and then the first layer 2 are selectively removed.

Regardless of the method chosen for selective removal of substance in the first recycling step and that will remove the part of the donor wafer 10 on the same side as the useful layer, there is a stop layer for removal of substance (the first layer 2 in the case of the first selective removal of substance or the zone subjacent to the first layer 2 included in the third layer 3A in the case of the second selective removal of substance).

The stop layer thus acts as a barrier for material attack, and in particular protects the third layer 3A in which there is a new useful layer to be taken off during a later taking off.

In another configuration of the donor wafer 10 before taking off, the donor wafer comprises several triplets each composed of the said first layer 2, second layer 3B and the third layer 3A, the second layer 3B and / or the first layer 2 of each triplet possibly being removed selectively with respect to the layer subjacent to them and forming part of the same triplet, by a means capable of removing the material selectively.

Advantageously, there is also a method of removing material in a third layer 3B of a triplet selectively with respect to a layer subjacent to it that is also included in the multi-layer structure I.

This latter configuration has the advantage that any layer in a triplet of layers can be selectively removed during recycling.

In the same configuration and in a first particular case, the layer subjacent to the third layer 3B is a second layer 3A belonging to another triplet of layers.

Still in this configuration and in a second special case, the layer subjacent to the third layer 3B is a first layer 2 that does not belong to the same triplet as layer 3B.

In this second particular case, the first layer 2 in the triplet overlying it and to which the third layer 3B belongs is advantageously inserted with another triplet subjacent to it. In this case, the result is an assembly formed from a sequence of type 3A layers and type 3B layers separated by a type 2 layer.

An example of a particular configuration of a multi-layer structure I comprising several such triplets of layers is given with reference to figure 4, in which the multi-layer structure I is composed of:

- a first triplet composed of a layer 2A of the first layer 2 type, inserted between a layer 3A of the third layer type 3A with reference to figure 2a, and a second layer 3B of the second layer type 3B with reference to figure 2a;
- a second triplet composed of a first layer 2C of the first layer type 2, inserted between a layer 3C of the third layer type 3A with reference to figure 2a, and a layer 3D of the second layer type 3B with reference to figure 2a; and
- a layer 2B of the first layer type 2 inserted between the two triplets.

The thickness of each of the layers 3A, 3B, 3C and 3D is equal to or greater than the thickness of the useful layer to be taken off.

In this case, the first function of the layers 2A, 2B and 2C is to protect the layer subjacent to them from removal of substance applied during recycling by:

- forming a stop layer to selective removal of the layer overlying it during recycling; and / or by
- forming a layer to be removed selectively with respect to the layer subjacent to it.

Therefore in this configuration of a donor wafer 10, there are layers 3A, 3B, 3C and 3D in which useful layers can be taken off, separated by protection layers 2A, 2B and 2C respectively protecting the layers subjacent to them during recycling.

Therefore, according to one process according to the invention, one or several layers can be taken off in one or several steps, with one or more intermediate recycling operations according to the invention applied particularly by removal of the part of the layer remaining after taking off selectively with respect to the first protection layer encountered (2A, 2B or 2C), this layer thus protecting a layer subjacent to it and that comprises at least one useful layer that can be taken off.

Thus, with this particular configuration it is possible to take off useful layers composed of one or several layers of materials.

When several layers are taken off, at least one protection layer or part of a protection layer such as layers 2A, 2B and 2C are also taken off and can thus act as a protection layer when removing material selectively when the surface of the taken off useful layer is being finished rather than during recycling, particularly to remove surface roughness.

In general, and for a multi-layer structure I according to the invention in which several useful layers can be taken off between the recycling steps according to the invention, in one advantageous context, according to the invention, a cyclic process for taking off useful layers from a donor wafer 10 according to the invention is used by performing the following steps iteratively in turn:

- a taking off process; and
- a method of recycling according to the invention.

Before the cyclic taking off method is applied, a process for making the donor wafer 10 according to the invention can be implemented with one or several techniques for making thin layers on the substrate 1 described above.

The possibility of taking off several times according to this invention starting from a donor wafer 10 (such as one of those represented in figures 1a, 2a, 3 or 4) in the same structure I made on substrate 1 without necessarily forming additional layers in it and / or without necessarily applying a treatment to retrieve at least part of the substrate 1, saves time with implementation of the global taking off process, and makes implementation of the process easier and significantly less expensive than the different processes according to the state of the art.

After taking off and recycling several times in the multi-layer structure I, the number of taking off operations particularly being a function of the thickness of the multi-layer structure, the remaining multi-layer structure I is no longer sufficiently thick to contain a useful layer to be taken off.

The donor wafer 10 is then practically composed only of the substrate 1.

In a first case, the donor wafer 10 is thrown away and in this case the entire substrate 1 is lost, but making the substrate may be complex, long and expensive, particularly if the substrate 1 comprises a buffer structure.

In a second more beneficial case, at least part of the substrate 1 is recovered using a method of recycling.

If the substrate 1 comprises a buffer structure, three types of recycling of the substrate 1 may be applied:

- recycling comprising removal of the entire buffer structure, but in which it is possible to keep at least part of the support substrate on which the buffer structure was formed; however this recycling causes loss of part of the substrate 1 which is usually the most difficult and most expensive to make; and it requires the use of an additional step to form a buffer structure, for example if it is required to reform a substrate 1 equivalent to the substrate before recycling;
- recycling including removal of part of the buffer structure, and capable of keeping the support substrate on which the buffer structure was formed and part of the buffer structure, such as a buffer layer that is expensive to make; for example, when recycling is done, selective removal of substance is possible starting from a stop layer judiciously located in the buffer structure; an additional step to reform a buffer structure is advantageously applied particularly if it is required to reform a substrate 1 equivalent to the substrate before recycling;

- recycling including the removal of at least part of the remainder of the original multi-layer structure I, to keep the entire substrate I; a finishing step for the rest of the multi-layer structure I may be applied during recycling; for example by CMP, heat treatment, sacrificial oxidation, bombardment or other smoothing technique) and / or a selective substance removal may be applied using a stop layer, for example judiciously located between the multi-layer structure I and the substrate 1;

After recycling of the substrate 1, a new multi-layer structure I is then formed in which several useful layers may be taken off according to a process according to the invention.

This new multi-layer structure I may be almost identical to the structure before recycling.

This new multi-layer structure I may have a slightly different structure from the multi-layer structure I before recycling, by slightly modifying some manufacturing parameters. For example, the concentrations of some compounds in a material may be slightly modified.

In all cases, the multi-layer structure is advantageously made by growth of layers, for example by epitaxy using CVD or MBE.

In a first case, the growth of at least one layer within the multi-layer structure I is done in situ, directly in continuation with the formation of the subjacent growth support, the subjacent growth support in this case also advantageously being formed by layer growth.

In a second case, at least one of these layers is grown after a slight finishing step on the subjacent growth support surface, for example by CMP polishing, heat treatment or other smoothing technique.

In the rest of this document, we will present example configurations of donor wafers 10 comprising multi-layer structures I that can be implemented by a process according to the invention.

In particular, we will present materials that can advantageously be used in such donor wafers 10.

Some examples that we will give in detail sometimes comprise a buffer structure and a support substrate in the substrate 1, the buffer structure being made on the support substrate.

In some of the examples concerned, the buffer structure then has a first lattice parameter at the level of its support substrate and a second lattice parameter close to its interface with the subjacent multi-layer structure I.

This type of buffer structure comprises a buffer layer to make such an adaptation of the lattice parameter.

The first technique for making a buffer structure (as described above), usually used to obtain a buffer layer with this property, is to have a buffer layer composed of several atomic elements in which:

- at least one atomic element is included in the composition of the support substrate; and
- at least one atomic element that is not located in the support substrate at all, or only slightly, with a concentration that varies gradually through the thickness of the buffer layer.

The gradual concentration of this element in the buffer layer will be the main cause of the gradual variation of the lattice parameter in the buffer layer, metamorphically.

Thus, in this configuration, a buffer layer is mainly an alloy.

The atomic elements chosen for the composition of the support substrate for the buffer structure and the buffer layer may be of type IV, such as Si or Ge.

For example in this case, it would be possible to have an Si support substrate and an SiGe buffer layer with a concentration of Ge that varies gradually through the thickness between a value close to 0 at the interface with the support substrate and a determined value on the other face of the buffer layer.

In another case, the composition of the support substrate and / or the buffer layer may include a pair of type III-V atomic elements, such as a pair chosen from possible combinations of (Al, Ga, In) - (N, P, As).

For example, in this case it would be possible to have a support substrate made of AsGa and a buffer layer made of As and / or Ga and at least one other element, this latter element varying gradually in thickness between a value close to 0 at the interface with the support substrate and a determined value on the other face of the buffer layer.

The composition of the support substrate and / or the buffer layer may comprise a pair of type II-VI atomic elements, such as a pair chosen among possible combinations of (Zn, Cd) - (S, Se, Te).

We give a few examples of such configurations below:

The first five examples deal particularly with donor wafers 10 comprising a support substrate 1 made of Si and a buffer layer made ofSiGe or Si and other layers of Si and SiGe within the multi-layer structure I.

These wafers 10 are particularly useful when taking off layers of strained SiGe and / or Si to make SGOI, SOI or Si/SGOI structures.

In this context, the etching solution types used are different depending on the material (Si or SiGe) to be etched. Thus, etching solutions suitable for etching these materials will be classified in categories, assigning an identifier taken from the following list to each category:

- S1: selective etching solutions of Si with respect to SiGe such that a solution comprising at least one compound among KOH, $NH_4OH$ (ammonium hydroxide), TMAH, EDP or $HNO_3$ or solutions currently being studied combining agents such as $HNO_3$, $HNO_2H_2O_2$, HF, $H_2SO_4$, $H_2SO_2$, $CH_3COOH$, $H_2O_2$ and $H_2O$ as explained in document WO 99/53539, page 9.
- S2: selective etching solutions of SiGe with respect to Si such as a solution containing $HF,H_2O_2$, $CH_3COOH$ (selectivity about 1:1000) or HNA (hydrofluoric-nitric-acetic solution).
- Sc1: selective etching solutions of SiGe with a concentration of Ge significantly less than or equal to 20%, with respect to SiGe with a concentration of Ge equal to or greater than 25%, such as a solution containing TMAH or KOH.
- Sd1: selective etching solutions of undoped Si with respect to boron doped Si, preferably doped to more than $2 \times 10^{19}$ cm$^{-3}$, such as a solution containing EDP (ethylene diamine and pyrocathechol) KOH or $N_2H_2$ (hydrazine).

Example 1:

The donor wafer 10 is composed of:

- a substrate 1 composed of:

    - a support substrate made of Si;
    - a buffer structure made of SiGe made according to the said first technique for making a buffer structure, and comprising a buffer layer and an additional layer;
    - a multi-layer structure I comprising SiGe.

The concentration of Ge in the buffer layer preferably increases progressively from the interface with the support substrate, to vary the SiGe lattice parameter as explained above.

The thickness is typically between 1 and 3 micrometers for surface concentrations of Ge of less than 30% to obtain a good structural relaxation at the surface, and to confine defects related to the difference in the lattice parameter such that they are buried.

The additional layer is made of SiGe significantly relaxed by the buffer layer, with an advantageously uniform concentration of Ge almost identical to the concentration of the buffer layer close to their interface.

The concentration of germanium in the silicon within the relaxed SiGe layer is typically between 15% and 30%.

This limitation of 30% represents a typical limitation of current techniques, but it may vary in future years.

The thickness of the additional layer may vary very widely depending on the case, with a typical thickness of between 0.5 and 1 micron.

For example with reference to figure 2a, the multi-layer structure I before taking off advantageously comprises the triplet of the following layers:

- a layer 3A made of significantly relaxed SiGe with a thickness greater than the thickness of a useful layer to be taken off;
- a layer 2 on layer 3A;
- a layer 3B on the significantly relaxed SiGe layer 2 and with a thickness greater than the thickness of a useful layer to be taken off.

Layer 2 is composed of one of the following materials:

- strained Si; or
- strained SiGe.

Remember that in the case in which the layer 2 is made of strained Si or SiGe, the thickness of this layer 2 must not exceed a critical thickness.

Thus, for example, for a layer 2 made of strained Si inserted between two layers of SiGe with a concentration of Ge almost equal to 20%, the critical thickness is typically of the order of about 20 nanometers.

Several types of etching may advantageously be used after taking off part of layer 3B, depending on the material in layer 2:

- if the layer 2 is made of strained Si:

    - the overlying part made of SiGe is etched selectively with an S2 type solution; and / or
    - after the layer 3B remaining after taking off has been removed, the layer 2 is etched selectively with an S1 type solution.

- If layer 2 is made of strained SiGe with a concentration of Ge almost equal to or greater than 25% and the concentration of Ge in the overlying layer is almost equal to or less than 20%:

    - the overlying part made of SiGe is selectively etched with an Sc1 type solution.

- If layer 2 is made of SiGe with a concentration of Ge almost equal to or less than 20% and the concentration of Ge in the subjacent layer is almost equal to or greater than 25%:

    - after the layer 3B remaining after taking off has been removed, the layer 2 is etched selectively with a Sc1 type solution.

A layer 2 made of SiGe or Si may also be doped with doping elements such as boron or phosphorus, in order to improve the selectivity of chemical etching.

In one particular configuration of the multi-layer structure I, the multilayer structure I comprises several triplets of these layers 3A, 2 and 3B.

In one special case of this configuration, the multi-layer structure I is only composed of pairs of layers 2 and 3, for example as shown in figure 3.

In the latter case, there will advantageously be a layer 2 separating two consecutive triplets, such as the donor wafer 10 shown in figure 4.

It is then advantageous and easy to find all taking off formulas involving one or several layers taken off in one or in several operations, separated by method of recyclinges according to the invention advantageously including selective etching between SiGe and the material in a layer 2.

Example 2:

The donor wafer 10 is composed of:

- a substrate 1 composed of:

    - a support substrate made of Si;
    - a buffer structure made of SiGe made according to the said first technique for making a buffer structure, and comprising a buffer layer made ofSiGe and an additional layer made of Ge;

- a multi-layer structure I comprising AsGa and/or Al-GaAs before taking off.

The concentration of Ge in the buffer layer preferably increases progressively from the interface with the support substrate, to vary the lattice parameter of the Si support substrate with respect to the lattice parameter of the additional layer made of Ge.

The concentration of Ge in the buffer layer is increased from about 0 to about 100% or more precisely around 98% for a complete match in the theoretical mesh between the two materials.

For example with reference to figure 1a, the multi-layer structure I before taking off advantageously comprises the pair of the following layers:

- a layer 2 made of AlGaAs;
- a layer 3 on layer 2, layer 3 being made of significantly relaxed AsGa and with a thickness greater than the thickness of a useful layer to be taken off.

Taking off applies to the part of the multi-layer structure I above layer 2, and recycling includes selective chemical etching of layer 3 with a selective etching solution, such as a solution containing citric acid ($C_6H_8O_7$) and oxygenated water with a pH between about 6 and 7 (the selectivity coefficient is typically 20), so that almost the entire layer 3 can be taken off, in this case layer 2 behaving like an etching stop layer.

In one particular configuration of the multi-layer structure I, the multilayer structure I comprises another layer made ofAsGa subjacent to layer 2.

Taking off then applies to the part of the multi-layer structure I above this other AsGa layer, and recycling includes selective chemical etching of layer 2 with a selective etching solution, such as a solution containing dilute hydrofluoric acid (between about 9% and 48%) (the selectivity coefficient is typically between 350 and 10000), so that almost the entire layer 2 can be removed, with the other subjacent AsGa layer behaving like an etching stop layer.

In one special case, the two selective etchings can be done one after the other in order to remove at least part of layer 3 and then to remove layer 2.

In one particular configuration of the multi-layer structure I, the multilayer structure I comprises several pairs of these layers 2 and 3.

In one special case of this configuration, the multi-layer structure I is only composed of pairs of layers 2 and 3, for example as shown in figure 3.

It is then advantageous and easy to find all taking off formulas involving one or several layers taken off in one or in several operations, separated by method of recyclinges according to the invention advantageously including selective etching between AlGaAs and GaAs.

Example 3:

The donor wafer 10 is composed of:

- a substrate 1 composed of Si;
- a multi-layer structure I comprising Si before taking-off.

For example with reference to figure 2a, the multi-layer structure I before taking-off advantageously comprises the triplet of the following layers:

- a layer 3A made of significantly relaxed Si with a thickness greater than the thickness of a useful layer to be taken off;
- a layer 2 on layer 3A;
- a layer 3B on the significantly relaxed Si layer 2 and with a thickness greater than the thickness of a useful layer to be taken off.

Layer 2 is composed of one of the following materials:

- doped Si; or
- strained SiGe.

Remember that in the case in which the layer 2 is made of strained SiGe, the thickness of this layer 2 must not exceed a critical thickness related to the Ge concentration.

Several types of etching may advantageously be used after taking off part of layer 3B, depending on the material in layer 2:

- if the layer 2 is made of doped Si:

- the overlying part made of Si and left after taking off is etched selectively with an Sd1 type solution;
- if the layer 2 is made of strained SiGe:

- the overlying part made of Si is etched selectively with an S1 type solution; and/or

- after the layer 3B remaining after taking off has been removed, the layer 2 is etched selectively with an S2 type solution.

Example 4:

The donor wafer 10 is composed of:

- a substrate 1 composed of:

  - a support substrate made of Si;
  - a buffer layer made using the said second particular technique for making a buffer structure discussed above and divulged in document WO 00/15885, in other words by:

- a deposition of a first layer made of Ge or SiGe according to the said second particular technique for making a buffer structure discussed above and divulged in document WO 00/15885;
- possibly followed by deposition of a second optional layer that can improve the crystallographic quality of the overlying layer, as described in document WO 00/15885, the second layer being made of:
- SiGe (50/50) if the first layer in the buffer layer is made of Ge;
- strained Si if the first layer in the buffer layer is made of SiGe;
- a multi-layer structure I comprising a sequence of pairs of layers, each pair being composed of a relaxed layer 3 and a strained layer 2,
- each relaxed layer 3 is at least as thick as the a useful layer to be taken off and is made of:

  - Ge if the first layer made of the buffer layer is made of Ge; or
  - SiGe if the first layer made of the buffer layer is made of SiGe (with a concentration almost the same as the concentration of the first layer in the buffer layer);

- each strained layer 2 is made of strained Si or SiGe and its thickness is less than a critical thickness beyond which the elastic strain starts to relax, this critical thickness depending on the composition of the three adjacent relaxed layers made of Si.

Removal of the multi-layer structure I may apply to a set of layers or a single layer made of the multi-layer structure 1.

Thus, a relaxed layer 3, a strained layer 2 or a set of strained layers 2 and relaxed layers 3 may be taken off, to transfer them onto a receiving substrate 5.

If taking off takes place in a relaxed layer 3, recycling according to the invention can be implemented by chemically etching the rest of the relaxed layer 3 with a solution capable of etching the material in the layer 3 selectively with respect to the material in layer 2.

If layer 2 is made of Si and layer 3 is made of SiGe, the strained layer 2 will be etched with an S2 type solution, the strained layer 2 then being an etching stop layer. This etching may be followed by a second etching of the strained layer 2 that is selective with respect to another relaxed layer.

It is thus possible to implement a second taking off after a first taking off, the second taking off applying to the strained layer 2 and / or part of the subjacent multi-layer structure I.

Note that the structures obtained after taking off according to this example are free of any dislocation type defects, even in a buried region.

And the structures obtained as a result may then be used to grow additional layers, for example made of strained silicon, by epitaxy on the layer made of strained SiGe, Ge or Si.

Example 5:

The donor wafer 10 is composed of:

- a substrate 1 composed of:

  - a support substrate made of Si;
  - a buffer layer made of Si made according to the said third technique for making a buffer structure;

- a multi-layer structure I comprising the following triplet of successive layers:

  - a first layer 3A made of SiGe with at least 15% of Ge on the buffer structure, the SiGe being relaxed or pseudo-relaxed;
  - a second layer 2 made of strained Si with a thickness much less than the cumulated thicknesses of the first layer 3A and the second layer 3B;
  - a third layer 3B made of SiGe containing at least 15% of Ge, the SiGe being relaxed or pseudo-relaxed.

This donor wafer 10 is the wafer obtained after making the buffer layer according to the said third technique for producing the buffer structure.

In a first embodiment of the buffer layer, the triplet of layers was present before the buffer layer was made, the donor wafer 10 then being in the form of:

- a substrate 1 made of Si;
- a multi-layer structure I' composed of the following in sequence:

  - a first layer 3A' made of SiGe with at least 15% of Ge on the buffer structure, the SiGe being strained;
  - a second layer 2' made of relaxed Si;
  - a third layer 3B' made of SiGe containing at least 15% of Ge, the SiGe being strained.

The strained SiGe layer 3A' has approximately the same characteristics as the strained SiGe layer 3B'.

The density of defects such as dislocations in the multi-layer structure I' is advantageously less than about $10^7$ cm$^{-2}$.

Typical thicknesses of a multi-layer structure I' with layers 3A' and 3B' with 15% of Ge and a multi-layer structure I' with layers 3A' and 3B' with 30% Ge, are about 250 nm and about 100 nm respectively, thus remaining below the critical end of elastic strain thicknesses for each layer.

The typical thickness of the relaxed layer 2' is a few tens of nanometers.

The orders of magnitude of the thicknesses of the strained layers 3A' and 3B' are advantageously almost the same as each other.

Therefore, the multi-layer structure I' is globally strained.

According to the above, a buffer layer will be made in two main steps:

- formation of a disturbance area in the support substrate 1 made of Si by the implantation of atomic species such as H or He;
- heat treatment to cause at least relative relaxation of elastic strains in the multi-layer structure I'.
  Implantation energy ranges of H and He used during the first step are typically between 12 and 25 keV. Implanted H or He doses are typically between $10^{14}$ and $10^{17}$ cm$^{-2}$.
- Thus for example, for a strained layer 3A' with 15% of Ge, H will preferably be used for the implant at a dose of about $3 \times 10^{16}$ cm$^{-2}$ with an energy about 25 keV.
- Thus for example, for a strained layer with 2 to 30% of Ge, He will preferably be used for the implant at a dose of about $2 \times 10^{16}$ cm$^{-2}$ with an energy about 18 keV.

Implant depths of atomic species in the substrate 1 are also typically between 50 nm and 100 nm.

The heat treatment applied during the second step must be adapted particularly so that disturbances are displaced in the region between the disturbance zone and the multi-layer structure I'.

This region in which disturbances are displaced will then form the buffer layer.

The arrival of dislocations at the interface between the buffer layer and the multi-layer structure I' then causes a global relaxation of the multi-layer structure I' as follows:

- elastic relaxation of the strained layer 3A' to form the relaxed or pseudo-relaxed layer 3A;
- elastic strain in the relaxed layer 2' to form the strained layer 2, this layer then having a lattice parameter almost the same as the lattice parameter of the subjacent relaxed SiGe;
- elastic relaxation of the strained layer 3B' to form the relaxed or pseudo-relaxed layer 3B.

The movement of dislocations in the buffer layer also causes a large disappearance of dislocations in the multi-layer structure I'.

The heat treatment is preferably implemented under an inert atmosphere.

However, the heat treatment may be applied under another atmosphere, for example such as an oxidising atmosphere;

Thus, a particular heat treatment to be applied for this type of donor wafer 10 will be made at temperatures typically between 400°C and 1000°C for a duration varying from 30 s to 60 minutes, and more particularly from about 5 minutes to about 15 minutes.

In a second embodiment of the buffer layer, the triplet of layers was not present before the buffer layer was made, the donor wafer then advantageously having the following form:

- an Si substrate 1;
- a layer made ofSiGe containing at least 15% of Ge, the SiGe being elastically strained.

Relaxation techniques and parameters for this SiGe layer are almost the same as for the first embodiment of the buffer layer.

The next step after the buffer layer has been made is to grow layers forming the multi-layer structure comprising the said triplet of globally relaxed layers.

The multi-layer structure I is thus made after the buffer layer, unlike in the first embodiment proposed in this example.

For further information about experimental techniques, refer to studies done by B. Holländer et al., particularly in the document entitled "Strain relaxation of pseudomorphic Si1-xGex / Si(100) heterostructures after hydrogen or helium ion implantation for virtual substrate fabrication" (in Nuclear and Instruments and methods in Physics Research B 175-177 (2001) 357-367).

After the wafer 10 has been bonded onto a receiving substrate 5 on the relaxed layer 3B, taking-off is done with or without an intermediate bonding layer using one or more of the known techniques described above.

Some of the relaxed SiGe layer 3B is taken off.

Recycling is advantageously done by selective chemical etching of the residue of layer 3B using a type S2 solution, layer 2 then forming an etching stop layer.

A second selective chemical etching step of layer 2 can then be applied using an S1 type solution, the layer 3A forming an etching stop layer.

The result is a recycled donor wafer 10, that can give a new useful layer in layer 3A or a pair of layers 2/3A, by taking off.

Example 6:

The donor wafer 10 is composed of:

- a substrate 1 composed of:

    - a support structure at least part of which is composed of AsGa at its interface with the overlying buffer structure;
    - a buffer structure made of III-V material made according to the said first buffer structure manufacturing technique;

- a multi-layer structure I comprising an III-V material before taking-off.

The support structure may be made of solid AsGa or solid Ge, on which a thickness of AsGa is epitaxied.

The first advantage of the buffer structure is to adapt the lattice parameter with the material of the multi-layer structure I close to their interface (which for example may have a nominal value of 5.87 Angstroms in the case of InP), to the value of the AsGa (for which the nominal value is about 5.65 Angstroms).

In solid III-V materials, the practical advantage of such a buffer structure may for example become clear by comparing different materials such as solid InP and solid AsGa, for example solid AsGa being less expensive, more easily available on the semiconductors market, less weak mechanically, with the use of the best known rear face contact technologies, and being available in larger sizes (typically 6 inches instead of 4 inches for solid InP) than for solid InP.

However, the electronic performances of InP are usually more useful than the electronic performances of AsGa.

Thus, for example, the said donor wafer 10 gives a solution for the manufacture of a 6-inch InP layer, by proposing a multi-layer structure I comprising InP made on an AsGa support substrate and relaxed through a buffer structure.

Therefore, the possible advantages of such a donor wafer 10 become evident; it can be used to make an active layer made of a known III-V material to be transferred with determined quality and properties, for example that may be similar to the properties that could have been obtained if solid III-V material had been used.

The thickness of the buffer structure included within this type of donor wafer 10 is typically more than one micron, and this thickness will increase, particularly if it is possible to avoid destroying it after each taking off operation, particularly due to the use of a method of recycling according to this invention.

In the example of the multi-layer structure I comprising Inp essentially relaxed at its interface with the subjacent buffer structure, the buffer structure of the substrate 1 then advantageously comprises a buffer layer composed of InGaAs with a concentration of In varying between 0 and about 53%.

The buffer structure may also comprise an additional layer made of an III-V material such as InGaAs or InAlAs, with an almost constant concentration of atomic elements.

In a special taking off case, at least one InP layer is taken off in the multi-layer structure I so that it can be transferred onto a receiving substrate 5.

Thus, any electrical and electronic properties can be well used.

For example, this is the case if the taken off part also comprises InGaAs or InAlAs; discontinuities in electronic bands between the latter material and the Inp create significantly better electronic mobilities in the taking off layers.

Other configurations of donor wafers 10 are possible, including other III-V compounds.

Typical applications for these means of taking off layers include HEMT (High Electron Mobility Transistor) and HBT (Heterojunction Bipolar Transistor) implementations.

Chemical etching solutions, possibly selective and adapted to remove some III-V materials and not other III-V materials, are advantageously used during recycling.

Thus for example, selective etching of InP is advantageously used with a solution comprising concentrated HCl in order to remove an InP layer without taking off a subjacent layer made of InGaAs.

Example 7:

The donor wafer 10 is composed of:

- a substrate 1 composed of:

    - a support substrate made of AsGa at its interface with the overlying buffer structure;
    - a buffer structure made according to the said first technique for making a buffer structure, and comprising InGaAs at its interface with the multi-layer structure I;

- a multi-layer structure I comprising InP and/or $In_xGa_{1-x}As_yP_{1-y}$ before taking-off.

For example with reference to figure 1a, the multi-layer structure I before taking off advantageously comprises the pair of the following layers:

- a layer 2 made of InGaAs (P);

a layer 3 on layer 2, layer 3 being made of significantly relaxed InP and with a thickness greater than the thickness of a useful layer to be taken off.

This type of donor wafer 10 was described in example 6 above.

Taking off applies to the part of the multi-layer structure I above layer 2, and recycling includes selective chemical etching of layer 3 with a selective etching solution, such as a solution containing HF so that almost the entire layer 3 left after taking-off can be removed, in this case layer 2 behaving like an etching stop layer.

In one particular configuration of the multi-layer structure I, the multilayer structure I comprises another layer made of InP subjacent to layer 2.

Taking off then applies to the part of the multilayer structure I above this other InP layer, and recycling includes selective chemical etching of layer 2 with a selective etching solution, such as a solution containing $Ce^{IV} H_2SO_4$ so that almost the entire layer 2 is removed, in this case the other subjacent InP layer behaving like an etching stop layer.

In a third case, the two selective etchings can be done one after the other in order to remove at least part of layer 3 and to remove layer 2.

In one particular configuration of the multi-layer structure I, the multilayer structure I comprises several pairs of these layers 2 and 3.

In one special case of this configuration, the multi-layer structure I is only composed of pairs of layers 2 and 3, for example as shown in figure 3.

It is then advantageous and easy to find all taking off formulas involving one or several layers taken off in one or in several operations, separated by method of recyclinges according to the invention advantageously including selective etching between InP and InGaAs (P).

Example 8:

The donor wafer 10 is composed of:

- a substrate 1 composed of:

   - a support substrate made of sapphire, or SiC, or Si,
   - a buffer structure made according to the said first technique for making a buffer layer composed of:

      - a metamorphic buffer layer made of $Al_x Ga_{1-x}$ N, where x varies in thickness from 0 to 1 starting from the interface with sapphire;
      - an additional layer made of GaN to confine dislocation type crystallographic defects;

- a multi-layer structure I comprising nitride layers.

The III-V GaN, AlN and InN nitrides are useful in microelectronics, particularly in light emitting devices such as lasers for applications such as reading or writing data stored at high density on compact disks or such as light emitting diodes for new display technologies. These materials are also suitable for making high power electronic components, or electronic components operating at high temperature.

One method of making the nitride layers included in the multi-layer structure I is epitaxial growth on the additional layer made of GaN by deposition of group I organic metals, such as Trimethyl Gallium, Trimethylamine Alane or Trimethyl Indium for the deposition of the GaN, AlN or InN layers respectively.

This invention used to transfer several of these nitride layers starting from the same donor wafer 10 implies a recycling step between each operation to take off a layer, in order to prepare another layer in the multilayer structure I for another taking off operation.

Thus, several techniques, mainly smoothing of layers by chemical etching, help to achieve this purpose while keeping the structural and geometric quality of the layer to be taken off intact or almost intact.

One example is a photo etching technique used to etch layers of GaN. For example, refer to the document by R.T. Leonard et al. ("Photo-assisted dry etching of GaN", in Applied Physics letters 68 (6), February 5 1996).

In the special example that will be dealt with here, the multi-layer structure I comprising nitrides is like that shown in figures 2 and 4.

With reference to figure 2a, the multi-layer structure I before taking off advantageously comprises the following triplet of layers:

- a layer 3A made of AlN,
- a layer 2 made of InN,
- a layer 3B made of GaN.
   Advantageously, the multi-layer structure I comprises another almost identical triplet of layers, separated from the first triplet by a layer made of InN.
   The advantage of this three-layer structure lies in the choice of materials for which chemical attack means are available that are significantly different for each of the materials.
- Thus, InN has a lower dry etching rate than GaN or AlN if a plasma gas comprising polarised chlorine, hydrogen and possibly argon is injected on the wafer 10, particularly adapting the technical parameters as follows:

- power of polarising radio frequencies preferably between 400 and 1000 Watts, and more particularly at about 650 Watts;
- temperature between 500 and 1000 ° Kelvin, preferably closer to 1000;
- low pressure of the order of 1 mT;

- composition with Cl$_2$ to H$_2$ ratio equal to the order of 2 to 3, for a total fluidic ratio of about 25 sccm.

The etching selectivity of GaN and AlN compared with InN is mainly due to the low volatility of InCl$_x$ species compared with the volatility of species containing Ga and Al.

N atoms in nitrides combine very well with H$_2$ to form gaseous molecules of NH$_3$.

With reference to the experimental results obtained by S.J. Pearton et al. in "Law Bias Electron Cyclotron Resonance Plasma Etching of GaN, AlN and InN" (Applied Physics Letters 64 (17), April 25 1994), the etching ratio of GaN with respect to InN may be more than 3 to 1, and the etching ratio of AlN with respect to InN may be of the order of 5 to 1.

Still referring to the said document by S.J. Pearton et al, an etching ratio of GaN with respect to AlN of the order of 2 to 1 can be obtained, and a dry etching ratio of InN with respect to AlN of the order of 3 to 2 can be obtained.

If taking off is done in the GaN layer, a gas comprising polarised chlorine can advantageously be used so that the subjacent layer made of InN forms an etching stop layer.

If it is not required to keep the InN layer, dry etching can be applied using a gas containing CH$_2$, so that the subjacent layer made of AlN forms an etching stop layer.

An additional finishing step, for example by polishing, may be used to finish the surface of the layer kept after etching.

This layer kept after etching may then be taken off again according to the invention.

Similarly, if taking off is done in the InN layer, the residue of the InN layer can advantageously be dry etched using gas containing CH$_2$ so that the InN layer forms a stop layer.

If it is not required to keep the layer made of AlN, it would be possible to implement dry etching using gas containing chlorine so that the subjacent InN layer forms a stop layer.

Finally, if a layer made of AlN is taken off, dry etching can advantageously be used using chlorine gas while the subjacent InN layer forms a stop layer.

Several layers can also be taken off in a single taking off operation, particularly if there are several triplets (AlN, InN, GaN) separated by an InN layer.

Example 9:

The donor wafer 10 is composed of:

- a substrate 1 composed of:

  - a support substrate made of sapphire or SiC or Si;
  - an intermediate layer made ofGaN;

- a SiO$_2$ mask;
- a GaN buffer layer;
- a multi-layer structure I comprising successive layers of nitrides, including at least one layer made ofGaN.

The method of making the buffer layer is as described above in this document, in the presentation of the said fourth technique for making the buffer structure, and it consists of anisotropically growing nitride layers, particularly GaN, using the ELOG technique.

The SiO$_2$ mask used in this configuration is advantageously in the form of bands arranged periodically on the intermediate layer made ofGaN, and almost parallel to each other.

The thickness of each band is typically of the order of a few tens of a micron, while the width of a band is of the order of a few microns.

The distance separating the bands from each other is typically about 10 microns or 15 microns.

For example, there could be a network of bands at 13 micron intervals, each band being 0.2 microns thick and 5 microns wide.

As described above in a general case, these SiO$_2$ bands will cause localised dislocations in the GaN layer(s) deposited above, close to the free surface of these bands.

The thickness of GaN in which these dislocations are located around the mask then forms the said buffer layer.

The layers of GaN or other materials with lattice parameters similar to the lattice parameters of GaN are deposited on the buffer layer to form the said multi-layer structure I.

This multi-layer structure I then comprises at least two layers each with a thickness equal to or greater than the thickness of a useful layer that is to be taken off.

For further information about the method of making a wafer according to the ELOG process, refer to the document drawn from "MRS Bulletin" May 1998, volume 23, No. 5, Article by Shuji Nakamura entitled "In/GaN/AlGaN-Based Laser Diodes with an Estimated Lifetime of Longer than 10,000 Hours".

In particular, in this multi-layer structure I, stop layers with selective chemical etchings such as InN layers as described previously in example 8 can be integrated during manufacturing.

Thus, after taking off a layer made ofGaN, recycling according to the invention can be implemented by etching the GaN selectively with respect to the subjacent InN layer using an etching gas containing polarised chlorine as previously described in example 8.

Other constituents can be added into the semiconducting layers presented in this document, for example such as carbon with a carbon concentration in the layer considered being significantly less than or equal to 50% or more particularly with a concentration less than or equal to 5%.

Finally, this invention is not restricted to a donor wafer 10 made of materials presented in the above examples, but also covers other types of materials belonging to the II, III, IV, V or VI atomic families and to alloys belonging to the IV-IV, III-V, II-VI atomic families.

Note that in the case of alloy materials, the alloys chosen may be binary, ternary, quaternary or higher degree.

If the donor wafer 10 comprises a buffer layer or a buffer structure, this invention is not limited to a buffer layer or a buffer structure which has the prime function of adapting the lattice parameter between two adjacent structures with different lattice parameters, but also concerns any buffer layer or buffer structure as defined more generally in this document.

Furthermore, the final structures obtained as a result of taking off useful layers are not restricted to SGOI, SOI, Si/SGOI structures, nor are they restricted to structures for HEMT and HBT transistors nor to structures for applications in lasers.

**Claims**

1. Method of taking-off a useful layer from a donor wafer (10) which comprises successively a substrate (1) and several layers of crystalline materials termed "a multi-layer structure" (I), said multi-layer structure (I) comprising, before taking-off, the useful layer (3, 3B, 3D) to be taken off, and said useful layer comprising a material chosen from semiconductor materials, this method of taking-off comprising :

    - a recycling of the donor wafer (10) after having carried out therefrom the taking-off of the useful layer (3, 3B, 3D), this recycling process comprising removal of substance on the side where this taking-off took place, and
    - a subsequent taking-off of one other useful layer (2, 2A, 2B, 2C, 3A, 3C) from the donor wafer (10),

    **characterized in that** the multi-layer structure (I) further comprises at least said other useful layer (2, 2A, 2B, 2C, 3A, 3C) before the first taking-off, **in that** after the removal of substance occurring during said recycling, at least a part (I') of the multilayer structure (I) remains on said substrate (1) of the donor wafer (10) this remaining part (I') including at least said other useful layer (2, 2A, 2B, 2C, 3A, 3C) that can be taken off during said subsequent taking-off, without a supplementary step of reforming said other useful layer.

2. Method according to claim 1, **characterized in that** the removal of substance comprises chemical etching.

3. Method according to claim 1 or 2, **characterized in that** the multi-layer structure (I) comprises before taking-off a first layer (2) and a second layer (3) on the first layer (2).

4. Method according to claim 3, **characterized in that** the first layer (2) comprises the useful layer that can be taken off after recycling.

5. Method according to claims 3 or 4, **characterized in that** the two materials of the respective two layers (2, 3) close to their interface, are chosen such that there is means for selectively removing material, with a capacity for attacking the second layer (3) to be removed significantly greater than its capacity for attacking the first layer (2), thus the first layer (2) forming a stop layer of the removal of the second layer (3), and **in that** this process comprises the selective removal of substance.

6. Method according to claim 5, **characterized in that** the multi-layer structure (I) comprises several pairs, each composed of the said first layer (2) and second layer (3), the second layer (3) of each pair can be selectively removed with respect to the first layer (2) in the same pair by means capable of selectively removing material.

7. Method according to one of claims 3 to 6, **characterized in that** the multi-layer structure (I) after taking-off, also comprises a third layer (3A) beneath the first layer (2), the third layer (3A) comprising the useful layer that can be subsequently taken off after recycling.

8. Method according to claim 7, **characterized in that** the first layer (2) is inserted between a second layer (3B) and a third layer (3A), **in that** the natural lattice parameter of the material of the first layer (2) is significantly different from the lattice parameter of the second and third layers (3B, 3A), and **in that** the thickness of the first layer (2) is small enough for being elastically strained by the second and the third layers (3B, 3A).

9. Method according to any one of the two previous claims 7 or 8, **characterized in that** the two materials of the respective first layer (2) and third layer (3A) are chosen such that there is means for selectively removing substance with a capacity for attacking the first layer (2) to be removed significantly greater than the capacity for attacking the third layer (3A), the third layer (3A) forming thus a stop-layer of the removal of the first layer (2), and **in that** the process comprises implementation of such a selective removal of substance.

10. Method according to any one of claims 7 to 9, **char-**

acterized in that the multi-layer structure comprises several triplets each composed of the said third layer (3A), first layer (2) and second layer (3B), one of these layers possibly being removed selectively with respect to the layer forming part of the same triplet and beneath it, by means capable of removing selectively the substance.

11. Method according to any one of claims 5, 6, 9 and 10, **characterized in that** selective removal of substance comprises a selective chemical etching.

12. Method according to claim 11, **characterized in that** the selectivity of chemical etching between the two materials considered is obtained by the fact that:

    - the two materials are different; or
    - the two materials contain almost identical atomic elements, except for at least one atomic element; or
    - the two materials are almost identical, but the atomic concentration of at least one atomic element in a material is significantly different from the atomic concentration of the same atomic element in the other material; or
    - the two materials have different porosity densities.

13. Method according to claim 12, **characterized in that** the selectivity of etching between the two materials considered is obtained by the fact that the two materials contain almost identical atomic elements, except for at least one additional atomic element located in the first layer, and wherein the additional atomic element is a doping element.

14. Method according to any one of claims 11, 12 and 13, wherein a mechanical attack of the material to be removed is operated in combination with the selective chemical etching, so that a selective mechanical-chemical planarisation is used.

15. Method according to any one of claims 5, 6, 9 and 10, **characterized in that** the selective removal of substance comprises a selective mechanical attack.

16. Method according to claim 15, **characterized in that** the selective mechanical attack is done by polishing, possibly associated with abrasive and / or chemical etching.

17. Method according to any one of claims 5, 6, 9 and 10, **characterized in that** a selective removal of substance comprises a removal of an oxide layer by a deoxidation step, the oxide layer thus being sacrificial.

18. Method according to claim 17, **characterized in that** comprising further a surface oxidation of the multi-layer structure (I) to form the sacrificial oxide layer.

19. Method according to claim 18, **characterized in that** the surface oxidation process is used so that it is easier to oxidise the surface layer than the layer beneath it.

20. Method according to claim 1, **characterized in that** the substrate (1) comprises a support substrate and a buffer layer, the buffer layer being located between the support substrate and the multi-layer structure (I), the buffer layer being of a crystalline material having a constant chemical composition and a lattice mismatch with the support substrate, confining crystallographic defects.

21. Method according to claim 20, **characterized in that** the buffer layer is of Si, SiGe, Ge or a nitride material, and **in that**, the multi-layer structure (I) comprises at least one of the following materials: elastically strained Si, or SiGe or Ge.

22. Method according to any claims 1 to 19, **characterized in that** the substrate (I) comprises a support substrate and a buffer structure with a lattice parameter varying significantly and progressively through its thickness between the lattice parameter of the support substrate and another lattice parameter significantly different from the lattice parameter of the support substrate.

23. Method according to claim 22, **characterized in that** the buffer structure also comprises an additional layer on the buffer layer, which:

    - is sufficiently thick to confine defects; and / or
    - has a surface lattice parameter slightly different from the lattice parameter of the support substrate.

24. Method according to one of claims 21, 22 and 23, **characterized in that** the buffer structure and the multi-layer structure (I) both comprise atomic alloy belonging to one of the following atomic alloy families:

    IV-IV family;
    III-V family;
    II-VI family;

    this alloy being of the binary, ternary, quaternary or higher degree type.

25. Method according to one of claims 1 to 19, **characterized in that** the substrate (1) comprises:

    - in a first configuration:

- a support substrate of Si;
- a buffer structure comprising a buffer layer of SiGe with a Ge concentration gradually increasing with the thickness and an additional layer of SiGe relaxed by the buffer layer;
- a multi-layer structure (I) comprising, before taking-off, elastically strained SiGe and / or Si; or

- in a second configuration:

- a support substrate of Si;
- a buffer structure comprising a buffer layer of SiGe with a Ge concentration gradually increasing with the thickness and an additional layer of SiGe relaxed by the buffer layer
- the same layers and the same materials as in the first configuration, with the buffer layer having a Ge concentration increasing with the thickness between about 0% and about 100% and with the additional layer of SiGe relaxed by the buffer layer having a concentration of Si of almost zero;
- comprising, before taking-off, AsGa and / or Ge; or

- in a third configuration:
Si at least in a thick part interfaced with the multi-layer structure (I);

- comprising elastically strained SiGe and / or Si; or

- in a fourth configuration:

- a support substrate comprising AsGa at its interface with the buffer structure;
- a buffer structure comprising a buffer layer comprising an atomic alloy belonging to the III-IV family of the ternary type or a higher degree, the composition of which is chosen from among possible combinations of (Al, Ga, In) - (N, P, As), and at least two elements chosen from among the III family or at least two elements chosen from among the V family, these two elements having a concentration varying gradually within the thickness of the buffer layer;
- a multi-layer comprising, before taking-off, an alloy belonging to the III-V family; or

- in a fifth configuration: the same layers and the same materials as in the fourth configuration, except that:

- the buffer structure also has a lattice parameter similar to the lattice parameter of InP close to the face opposite its interface with the support substrate; and
- the multi-layer comprises, before taking-off, InP and / or InGaAs; or

- in a sixth configuration:

- a support substrate of sapphire or SiC or Si;
- a buffer layer of AlxGa1-xN, where x varies in thickness from 0 to 1 starting from the interface with the support substrate;
- optionally an additional layer of GaN, if any;
- a multi-layer comprising, before taking-off, AlN, InN and GaN; or

- in a seventh configuration:

- a support substrate of sapphire or SiC or Si;
- possibly a layer of GaN;
- a mask;
- a buffer layer of GaN;
- a multi-layer comprising, before taking-off, GaN and possibly other nitrides.

26. Method according to one of claims 3 to 19 combined with claim 25, **characterized in that** the multi-layer structure (I) comprises:

- in the first configuration:

- two layers of almost elastically relaxed SiGe; and
- an intermediate layer between the two SiGe layers composed of:
- Si elastically strained to have a lattice parameter similar to the lattice parameter of the adjacent SiGe areas; or
- SiGe with a Ge concentration significantly different from the Ge concentrations in each of the two adjacent layers, and being elastically strained to have a lattice parameter similar to the lattice parameter of the adjacent areas; or
- doped Si or doped SiGe;
at least one of these three layers being a stop layer for selective chemical etching of the layer overlying it; or

- in the second configuration:

- two layers of GaAs;
- one layer of AlGaAs intermediate between the two layers of GaAs;
at least one of these three layers being a stop layer for selective chemical etching of the layer overlying it ; or

- in the third configuration:

  - two layers of almost elastically relaxed Si; and
  - an intermediate layer between the two Si layers composed of:
  - SiGe elastically strained to have a lattice parameter similar to the lattice parameter of the adjacent Si areas; or
  - doped Si or doped SiGe;
  at least one of these three layers being a stop layer for selective chemical etching of the layer overlying it; or

- in the fifth configuration:

  - two layers of InP;
  - an intermediate layer of InGaAsP between the two layers of InP: at least one of these three layers being a stop layer for selective chemical etching of the layer overlying it.

- in the sixth configuration:

  - an intermediate layer of InN between a AlN layer and a GaN layer;

- in the seventh configuration:

  - an intermediate layer of InN between two layers of GaN.

27. Method according to any of the previous claims, **characterized in that** a finishing step of the surface of the donor wafer (10) is performed before or after removal of substance.

28. Method according to any of the previous claims, wherein the donor wafer (10) comprises at least one layer further comprising carbon with a carbon concentration in the layer significantly less than or equal to 50%.

29. Method according to any of the previous claims, wherein the donor wafer (10) comprises at least one layer further comprising carbon with a carbon concentration in the layer significantly less than or equal to 5%.

30. Method according to one of claims 1 to 29, **characterized in that** it comprises:

  (a) bonding of the donor wafer (10) with a receiving substrate (5) on the side of the useful layer to be taken off;

  (b) detaching the useful layer included in the multi-layer structure (I) of the donor wafer (10);

31. Method according to one of claims 5 to 21 combined with claim 30, **characterized in that** the multi-layer structure (I) of the donor wafer (10) comprises a stop layer to a substance removal of its overlied layer, and **in that** step (b) of detaching relates to a part of the multi-layer structure overlying the stop layer.

32. Method according to claims 30 or 31, **characterized in that** it comprises the formation of a bonding layer before step (a).

33. Method according to one of the claims 30, 31 and 32, **characterized in that:**

  - before step (a), it comprises a formation of an embrittlement beneath the useful layer and **in that**:
  - step (b) is applied by supplying energy into the embrittlement zone to detach a structure comprising the useful layer, from the donor wafer (10).

34. Method according to claim 33, **characterized in that** the embrittlement zone is formed by implantation of atomic species.

35. Method according to the previous claim 34, **characterized in that** the implanted atomic species comprise at least a proportion of hydrogen and/or helium.

36. Method according to claim 34, **characterized in that** the embrittlement zone is formed by porosification of a layer.

37. Method according to one of claims 30 to 36, **characterized in that** it comprises another step, after step (b), of finishing the surface of the useful layer at which the detachment took place.

38. Method according to one of claims 30 to 37, **characterized in that** the useful layer includes at least one of the following materials:

  SiGe, Si, an alloy belonging to the III-V family with a composition chosen from among possible combinations of (Al, Ga, In) - (N, P, As).

39. Method according to one of claims 30 to 37, **characterized in that** the useful layer is at least a part of a semiconductor layer of a semiconductor-on-insulator structure.

40. Method according to one of claims 30 to 39, **characterized in that** the steps of taking-off a useful layer and of recycling the donor wafer (10) are performed

## Patentansprüche

1. Verfahren zum Abnehmen einer Nutzschicht von einem Donor-Wafer (10), welcher nacheinander ein Substrat (1) und mehrere Schichten kristalliner Materialien, genannt "eine Mehrsehichtstruktur" (I), umfasst, wobei die Mehrschichtstruktur (I), vor dem Abnehmen, die Nutzschicht (3, 3B, 3D) die abgenommen werden soll, umfasst und wobei die Nutzschicht ein Material umfasst, das aus Halbleitermaterialien gewählt ist, wobei das Verfahren zum Abnehmen umfasst:

   - ein Recycling des Donor-Wafers (10) nachdem die Nutzschicht (3, 3B, 3D) abgenommen worden ist, wobei der Recyclingprozess ein Entfernen von Substanz auf der Seite umfasst, wo das Abnehmen stattgefunden hat, und
   - ein darauf folgendes Abnehmen einer weiteren Nutzschicht (2, 2A, 2B, 2C, 3A, 3C) von dem Donor-Wafer (10),

   **dadurch gekennzeichnet, dass** die Mehrschichtstruktur (1) vor dem ersten Abnehmen wenigstens die andere Nutzschicht (2, 2A, 2B, 2C, 3A, 3C) aufweist, so dass nach dem Entfernen von Substanz, das während des Recyclings stattfindet, wenigstens ein Teil (I') der Mehrschichtstruktur (I) auf dem Substrat (1) des Donor-Wafers (10) verbleibt, wobei dieser verbleibende Teil (I') wenigstens eine weitere Nutzschicht (2, 2A, 2B, 2C, 3A, 3C) umfasst, die während des folgenden Abnehmens abgenommen werden kann, ohne eine zusätzliche Umgestaltung der weiteren Nutzschicht.

2. Verfahren nach Anspruch 1, **dadurch gekennzeichnet, dass** das Entfernen von Substanz chemisches Ätzen umfasst.

3. Vorfahren nach einem der Ansprüche 1 oder 2, **dadurch gekennzeichnet, dass** die Mehrsehiehtstruktur (I) vor dem Abnehmen eine erste Schicht (2) und eine zweite Schicht (3) auf der ersten Schicht (2) umfasst.

4. Verfahren nach Anspruch 3, **dadurch gekennzeichnet, dass** die erste Schicht (2) die Nutzschicht umfasst, die nach dem Recycling abgenommen werden kann.

5. Verfahren nach einem der Ansprüche 3 oder 4, **dadurch gekennzeichnet, dass** die zwei Materialien der zwei Schichten (2, 3) in Nähe ihrer Grenzfläche jeweils so gewählt sind, dass es ein Mittel gibt, um Material selektiv zu entfernen, mit einem Vermögen, die zu entfernende zweite Schicht (3) anzugreifen, das signifikant stärker ist als sein Vermögen, die erste Schicht (2) anzugreifen, so dass die erste Schicht (2) eine Stoppschicht für die Entfernung der zweiten Schicht (3) bildet, und **dadurch**, dass dieser Prozess selektives Entfernen von Substanz umfasst.

6. Verfahren nach Anspruch 5, **dadurch gekennzeichnet, dass** die Mehrschichtstruktur (I) mehrere Paare umfasst, wobei jedes aus der ersten Schicht (2) und der zweiten Schicht (3) zusammengesetzt ist, wobei die zweite Schicht (3) von jedem Paar selektiv bezüglich der ersten Schicht (2) im gleichen Paar durch ein Mittel entfernt werden kann, das selektiv Material entfernen kann.

7. Verfahren nach einem der Ansprüche 3 bis 6, **dadurch gekennzeichnet, dass** die Mehrsehichtstruktur (I), nach dem Abnehmen, auch eine dritte Schicht (3A) unter der ersten Schicht (2) umfasst, wobei die dritte Schicht (3A) die Nutzschicht umfasst, die nachfolgend nach dem Recycling abgenommen werden kann.

8. Verfahren nach Anspruch 7, **dadurch gekennzeichnet, dass** die erste Schicht (2) zwischen einer zweiten Schicht (3B) und einer dritten Schicht (3A) eingefügt ist, wobei sich der natürliche Gitterparameter des Materials der ersten Schicht (2) signifikant von dem Gitterparameter der zweiten und der dritten Schicht (3B, 3A) unterscheidet und wobei die Dicke der ersten Schicht (2) klein genug ist, um durch die zweite und dritte Schicht (3B, 3A) elastisch verspannt zu sein.

9. Verfahren nach einem der zwei vorstehenden Ansprüche 7 oder 8, **dadurch gekennzeichnet, dass** die zwei Materialien der ersten Schicht (2) und der dritten Schicht (3A) jeweils so gewählt sind, dass es Mittel zum selektiven Entfernen von Substanz gibt, mit einem Vermögen, die zu entfernende erste Schicht (2) anzugreifen, das signifikant stärker ist als das Vermögen, die dritte Schicht (3A) anzugreifen, wodurch die dritte Schicht (3A) eine Stoppschicht für das Entfernen der ersten Schicht (2A) bildet, und wobei der Prozess einen Einsatz von solch einem selektiven Entfernen von Substanz umfasst.

10. Verfahren nach einem der Ansprüche 7 bis 9, **dadurch gekennzeichnet, dass** die Mehrschichtstruktur mehrere Dreiergruppen umfasst, von denen jede aus der dritten Schicht (3A), der ersten Schicht (2) und der zweiten Schicht (3B) zusammengesetzt ist, wobei eine dieser Schichten möglicherweise selektiv bezüglich der Schicht, die einen Teil der gleichen Dreiergruppe bildet und darunter ist, entfernt wird, durch ein Mittel, das fähig ist, die Substanz selektiv zu entfernen.

**11.** Verfahren nach einem der Ansprüche 5, 6, 9 und 10, **dadurch gekennzeichnet, dass** selektives Entfernen von Substanz ein selektiv chemisches Ätzen umfasst.

**12.** Verfahren nach Anspruch 11, **dadurch gekennzeichnet, dass** die Selektivität des chemischen Ätzens zwischen den zwei betrachteten Materialien **dadurch** erhalten wird, dass:

> - die zwei Materialien unterschiedlich sind; oder
> - die zwei Materialien fast identische atomare Elemente umfassen, außer wenigstens einem atomaren Element; oder
> - die zwei Materialien fast identisch sind, aber sich die atomare Konzentration von wenigstens einem atomaren Element in einem Material signifikant von der atomaren Konzentration des gleichen atomaren Elements in dem anderen Material unterscheidet; oder
> - die zwei Materialien verschiedene Porositätsdichten aufweisen.

**13.** Verfahren nach Anspruch 12, **dadurch gekennzeichnet, dass** die Selektivität des Ätzens zwischen zwei betrachteten Materialien **dadurch** erhalten wird, dass die zwei Materialien fast identische atomare Elemente enthalten, außer wenigstens einem zusätzlichen atomaren Element, das sich in der ersten Schicht befindet und wobei das zusätzliche atomare Element ein Dotierelement ist.

**14.** Verfahren nach einem der Ansprüche 11, 12 und 13, bei welchem ein mechanischer Angriff des zu entfernenden Materials in Verbindung mit dem selektiven chemischen Ätzen durchgeführt wird, so dass ein selektives mechanisch-chemisches Planarisieren verwendet wird.

**15.** Verfahren nach einem der Ansprüche 5, 6, 9 und 10, **dadurch gekennzeichnet, dass** das selektive Entfernen von Substanz einen selektiven mechanischen Angriff umfasst.

**16.** Verfahren nach Anspruch 15, **dadurch gekennzeichnet, dass** der selektive mechanische Angriff durch Polieren durchgeführt wird, möglicherweise verbunden mit einem Schleifmittel und/oder chemischem Ätzen.

**17.** Verfahren nach einem der Ansprüche 5, 6, 9 und 10, **dadurch gekennzeichnet, dass** ein selektives Entfernen von Substanz ein Entfernen einer Oxydschicht durch eine Deoxidation umfasst, die Oxydschicht ist daher eine Opferoxydschicht.

**18.** Verfahren nach Anspruch 17, des Weiteren eine Oberflächenoxidation der Mehrschichtstruktur (I) umfassend, um die Opferoxidschicht zu bilden.

**19.** Verfahren nach Anspruch 18, **dadurch gekennzeichnet, dass** der Oberflächenoxidationsprozess verwendet wird, so dass es leichter ist, die Oberflächeusehicht zu oxidieren, als die Schicht darunter.

**20.** Verfahren nach Anspruch 1, **dadurch gekennzeichnet, dass** das Substrat (1) ein Trägersubstrat und eine Pufferschicht umfasst, wobei sich die Pufferschicht zwischen dem Trägersubstrat und der Mehrschichtstruktur (I) befindet, wobei die Pufferschicht aus einem kristallinen Material ist, das eine konstante chemische Zusammensetzung und einen Gitterversatz zu dem Trägersubstrat aufweist, der kristallographe Defekte beschränkt.

**21.** Verfahren nach Anspruch 20, **dadurch gekennzeichnet, dass** die Pufferschicht aus Si, SiGe, Ge oder einem Nitrid-Material ist, und dass die Mehrsehichtstruktur (I) wenigstens eines der folgenden Materialien umfasst: elastisch verspanntes Si, oder SiGe oder Ge.

**22.** Verfahren nach einem der Ansprüche 1 bis 19, **dadurch gekennzeichnet, dass** das Substrat (1) ein Trägersubstrat und eine Pufferstruktur mit einem Gitterparameter umfasst, der sich signifikant und fortschreitend über seine Dicke zwischen dem Gitterparameter des Trägersubstrats und einem anderen Gitterparameter verändert, der sich von dem Gitterparameter des Trägersubstrats signifikant unterscheidet.

**23.** Verfahren nach Anspruch 22, **dadurch gekennzeichnet, dass** die Pufferstruktur auch eine zusätzliche Schicht auf der Pufferschicht umfasst, welche:

> - ausreichend dick ist, um Defekte zu beschränken; und/oder
> - einen Oberflächengitterparameter aufweist, der sich von dem Gitterparameter des Trägersubstrats etwas unterscheidet.

**24.** Verfahren nach einem der Ansprüche 21, 22 und 23, **dadurch gekennzeichnet, dass** die Pufferstruktur und die Mehrschichtstruktur (I) jeweils eine atomare Legierung umfassen, die zu einer der folgenden atomaren Legierungsgruppen gehört:

> IV-IV Gruppe;
> III-V Gruppe;
> II-VI Gruppe;

wobei diese Legierung vom binären, ternären, quaternären oder höhergradigen Typ ist.

**25.** Verfahren nach einem der Ansprüche 1 bis 19, **da-**

**durch gekennzeichnet, dass** das Substrat (1) umfasst:

- in einer ersten Anordnung:

  - ein Trägersubstrat aus Si;
  - eine Pufferstruktur umfassend eine Pufferschicht aus SiGe mit einer Ge-Konzentration, die mit der Dikke allmählich zunimmt und einer zusätzlichen Schicht aus SiGe, die durch die Pufferschicht entspannt ist;
  - eine Mehrsehichtstruktur (I), die vor dem Abnehmen elastisch verspanntes SiGe und/oder Si umfasst; oder

- in einer zweiten Anordnung:

  - ein Trägersubstrat aus Si;
  - eine Pufferstruktur, umfassend eine Pufferschicht aus SiGe mit einer Ge-Konzentration, die mit der Dikke allmählich zunimmt, und einer zusätzlichen Schicht aus SiGe, die durch die Pufferschicht entspannt ist;
  - die gleichen Schichten und die gleichen Materialien wie in der ersten Anordnung, wobei die Pufferschicht eine Ge-Konzentration aufweist, die mit der Dicke zwischen ungefähr 0 % und ungefähr 100 % zunimmt, und mit der zusätzlichen Schicht aus SiGe, die durch die Pufferschicht entspannt ist, die eine Si-Konzentration von fast Null aufweist;
  - vor der Abnahme AsGa und/oder Ge umfassend; oder
  in einer dritten Anordnung:
  - Si, das wenigstens in einem dicken Teil mit der Mehrschichtstruktur (I) gekoppelt ist;
  - elastisch verspanntes SiGe und/oder Si umfassend; oder

- in einer vierten Anordnung:

  - ein Trägersubstrat, das AsGa an seiner Grenzfläche mit der Pufferstruktur umfasst;
  - eine Pufferstruktur, eine Pufferschicht umfassend, die eine atomare Legierung umfasst, die zu der III-IV Gruppe des ternären Typs oder eines höheren Grades gehört, dessen Zusammensetzung aus möglichen Kombinationen von (Al, Ga, In)-(N, P, As) gewählt ist, und wenigstens zwei Elementen, die aus der III. Gruppe gewählt sind, oder wenigstens zwei Elemente, die aus der V. Gruppe gewählt sind, wobei diese zwei Elemente eine Konzentration aufweisen, die sich in der Dicke der Pufferschicht allmählich verändert;

  - eine Mehrfachschicht vor der Abnahme eine Legierung umfassend, die zu der III-V Gruppe gehört; oder

- in einer fünften Anordnung: die gleichen Schichten und die gleichen Materialien wie in der vierten Anordnung, außer dass:

  - die Pufferstruktur auch in Nähe der Fläche, die ihrer Grenzfläche mit dem Trägersubstrat gegenüberliegt, einen Gitterparameter aufweist, der dem Gitterparameter von InP ähnelt; und
  - die Mehrfachschicht, vor der Abnahme, InP und/oder InGaAs umfasst; oder

- in einer sechsten Anordnung:

  - ein Trägersubstrat aus Saphir oder SiC oder Si;
  - eine Pufferschicht aus $Al_x Ga_{1-x} N$, wobei sich x über die Dicke von 0 bis 1 ändert, beginnend an der Grenzfläche mit dem Trägersubstrat;
  - wahlweise eine zusätzliche Schicht aus GaN, wenn überhaupt;
  - eine Mehrfachschicht, die vor der Abnahme AlN, InN und GaN umfasst; oder

- in einer siebten Anordnung:

  - ein Trägersubstrat aus Saphir oder SiC oder Si;
  - möglicherweise eine Schicht aus GaN;
  - eine Maske;
  - eine Pufferschicht aus GaN;
  - eine Mehrfachschicht, die vor der Abnahme, GaN und möglicherweise andere Nitride umfasst.

**26.** Verfahren nach einem der Ansprüche 3 bis 19 in Verbindung mit Anspruch 25, **dadurch gekennzeichnet, dass** die Mehrfachschichtstruktur (I) umfasst:

- in der ersten Anordnung:

  - zwei Schichten aus elastisch fast entspanntem SiGe; und
  - eine Zwischenschicht zwischen den zwei SiGe-Schichten, zusammengesetzt aus:
  - Si, das elastisch so verspannt ist, dass es einen Gitterparameter aufweist, der dem Gitterparameter der benachbarten SiGe-Bereiche ähnelt; oder
  - SiGe mit einer Ge-Konzentration, die sich von den Ge-Konzentrationen in jeder der zwei benachbarten Schichten signifikant unterscheidet, und das elastisch verspannt ist, so dass es einen Gitterparameter aufweist, der dem Gitterparameter der benachbarten Bereiche ähnelt; oder
- dotiertes Si oder dotiertes SiGe;

wobei wenigstens eine dieser drei Schichten eine Stoppschicht für selektives chemisches Ätzen der Schicht ist, die sie überlagert; oder
- in der zweiten Anordnung:

    - zwei Schichten aus GaAs;
    - eine Schicht aus AlGaAs zwischen den zwei Schichten aus GaAs;

wobei wenigstens eine dieser drei Schichten eine Stoppschicht für selektives chemisches Ätzen der Schicht ist, die sie überlagert; oder
- in der dritten Anordnung:

    - zwei Schichten von elastisch fast entspanntem Si; und
    - eine Zwischenschicht zwischen den zwei Si Schichten, die zusammengesetzt ist aus:
    - SiGe, das elastisch verspannt ist, so dass es einen Gitterparameter aufweist, der dem Gitterparameter der benachbarten Si-Bereiche ähnelt; oder
    - dotiertes Si oder dotiertes SiGe;

wobei wenigstens eine dieser drei Schichten eine Stoppschicht für selektives chemisches Ätzen der Schicht ist, die sie überlagert; oder
- in der fünften Anordnung:

    - zwei Schichten aus InP;
    - eine Zwischenschicht aus InGaAsP zwischen den zwei Schichten aus InP;

wobei wenigstens eine dieser drei Schichten eine Stoppschicht für selektives chemisches Ätzen der Schicht ist, die sie überlagert;
- in der sechsten Anordnung:

    - eine Zwischenschicht aus InN zwischen einer AlN-Schicht und einer GaN-Schicht;

- in der siebten Anordnung:

    - eine Zwischenschicht aus InN zwischen zwei Schichten aus GaN.

27. Verfahren nach einem der vorstehenden Ansprüche, **dadurch gekennzeichnet, dass** eine Endbearbeitung der Oberfläche des Donor-Wafers (10) durchgeführt wird, bevor oder nachdem Substanz entfernt wurde.

28. Verfahren nach einem der vorstehenden Ansprüche, bei welchem der Donor-Wafer (10) wenigstens eine Schicht umfasst, die des Weiteren Kohlenstoff umfasst, mit einer Kohlenstoffkonzentration in der Schicht, die signifikant weniger oder gleich 50 % ist.

29. Verfahren nach einem der vorstehenden Ansprüche, bei welchem der Donor-Wafer (10) wenigstens eine Schicht umfasst, die des Weiteren Kohlenstoff umfasst, mit einer Kohlenstoffkonzentration in der Schicht, die signifikant weniger oder gleich 5 % ist.

30. Verfahren nach einem der Ansprüche 1 bis 29, umfassend:

    (a) Verbinden des Donor-Wafers (10) mit einem aufnehmenden Substrat (5) auf der Seite der Nutzschicht, die abgenommen werden soll;
    (b) Ablösen der Nutzschicht, die in der Mehrschichtstruktur (I) des Donor-Wafers (10) enthalten ist.

31. Verfahren nach einem der Ansprüche 5 bis 21 in Verbindung mit Anspruch 30, **dadurch gekennzeichnet, dass** die Mehrschichtstruktur (I) des Donor-Wafers (10) eine Stoppschicht für eine Substanzentfernung der sie überlagernden Schicht umfasst, und dass sich Schritt (b) des Ablösens auf einen Teil der Mehrsehichtstruktur bezieht, der die Stoppschicht überlagert.

32. Verfahren nach einem der Ansprüche 30 oder 31, **dadurch gekennzeichnet, dass** es die Bildung einer Verbindungsschicht vor dem Schritt (a) umfasst.

33. Verfahren nach einem der Ansprüche 30, 31 und 32, **dadurch gekennzeichnet, dass:**

    - es vor Schritt (a) ein Bilden einer Versprödung unter der Nutzschicht umfasst und dass:
    - Schritt (b) angewandt wird, indem der Versprödungszone Energie zugeführt wird, um eine Struktur von dem Donor-Wafer (10) abzulösen, die die Nutzschicht umfasst.

34. Verfahren nach Anspruch 33, **dadurch gekennzeichnet, dass** die Versprödungszone durch Implantation von Atomarten gebildet wird.

35. Verfahren nach Anspruch 34, **dadurch gekennzeichnet, dass** die implantierten Atomarten wenigstens einen Anteil von Wasserstoff und/oder Helium umfassen.

36. Verfahren nach Anspruch 34, **dadurch gekennzeichnet, dass** die Versprödungszone durch Porosifizierung einer Schicht gebildet wird.

**37.** Verfahren nach einem der Ansprüche 30 bis 36, des weiteren eine Endbearbeitung der Oberfläche der Nutzschicht, an der Ablösen stattgefunden hat, nach Schritt (b) umfassend.

**38.** Verfahren nach einem der Ansprüche 30 bis 37, **dadurch gekennzeichnet, dass** die Nutzschicht wenigstens eines der folgenden Materialien umfasst:

SiGe, Si, eine Legierung, die zu der III-V Gruppe gehört, mit einer Zusammensetzung, die aus möglichen Kombinationen von (Al, Ga, In)-(N, P, As) gewählt ist.

**39.** Verfahren nach einem der Ansprüche 30 bis 37, **dadurch gekennzeichnet, dass** die Nutzschicht wenigstens ein Teil einer Halbleiterschicht einer Halbleiter-auf-Isolator-Struktur ist.

**40.** Verfahren nach einem der Ansprüche 30 bis 39, **dadurch gekennzeichnet, dass** das Abnehmen einer Nutzschicht und das Recycling des Donor-Wafers (10) iterativ der Reihe nach durchgeführt werden.

**Revendications**

**1.** Procédé pour enlever une couche utile d'une tranche donneuse (10) qui comprend successivement un substrat (1) et plusieurs couches de matériaux cristallins, appelés « structure multicouche » (I), ladite structure multicouche (I) comprenant, avant l'enlèvement, la couche utile (3, 3B, 3D) devant être enlevée, et ladite couche utile comprenant un matériau choisi parmi les matériaux semi-conducteurs, ledit procédé d'enlèvement comprenant :

- le recyclage de la tranche donneuse (10) après qu'a été mis en oeuvre sur celle-ci l'enlèvement de la couche utile (3, 3B, 3D), ce procédé de recyclage comprenant le retrait de la substance sur le côté où a eu lieu cet enlèvement, et
- un enlèvement subséquent d'une autre couche utile (2, 2A, 2B, 2C, 3A, 3C) de la tranche donneuse (10),

**caractérisé en ce que** la structure multicouche (I) comprend en outre au moins ladite autre couche utile (2, 2A, 2B, 2C, 3A, 3C) avant le premier enlèvement, **en ce qu'**après le retrait de substance qui a lieu durant ledit recyclage, au moins une partie (I') de la structure multicouche (I) reste sur ledit substrat (1) de la tranche donneuse (10), cette partie restante (I') comprenant au moins ladite autre couche utile (2, 2A, 2B, 2C, 3A, 3C) qui peut être enlevée durant ledit enlèvement subséquent, sans étape supplémentaire de reformation de ladite autre couche utile.

**2.** Procédé selon la revendication 1, **caractérisé en ce que** le retrait de substance comprend un décapage chimique.

**3.** Procédé selon la revendication 1 ou 2, **caractérisé en ce que** la structure multicouche (I) comprend, avant l'enlèvement, une première couche (2) et une deuxième couche (3) sur la première couche (2).

**4.** Procédé selon la revendication 3, **caractérisé en ce que** la première couche (2) comprend la couche utile qui peut être enlevée après recyclage.

**5.** Procédé selon la revendication 3 ou 4, **caractérisé en ce que** les deux matériaux des deux couches respectives (2, 3) près de leur interface sont choisis de façon qu'il y ait des moyens pour retirer sélectivement du matériau, avec une capacité pour attaquer la deuxième couche (3) devant être retirée significativement supérieure à sa capacité pour attaquer la première couche (2), la première couche (2) formant donc une couche d'arrêt du retrait de la deuxième couche (3), et **en ce que** ce procédé comprend le retrait sélectif de substance.

**6.** Procédé selon la revendication 5, **caractérisé en ce que** la structure multicouche (I) comprend plusieurs paires, composées chacune desdites première couche (2) et deuxième couche (3), la deuxième couche (3) de chaque paire pouvant être retirée sélectivement par rapport à la première couche (2) dans la même paire par des moyens capables de retirer sélectivement du matériau.

**7.** Procédé selon l'une des revendications 3 à 6, **caractérisé en ce que** la structure multicouche (I), après enlèvement, comprend aussi une troisième couche (3A) sous la première couche (2), la troisième couche (3A) comprenant la couche utile qui peut être ensuite enlevée après recyclage.

**8.** Procédé selon la revendication 7, **caractérisé en ce que** la première couche (2) est insérée entre une deuxième couche (3B) et une troisième couche (3A), **en ce que** le paramètre de réseau naturel du matériau de la première couche (2) est significativement différent du paramètre de réseau des deuxième et troisième couches (3B, 3A), et **en ce que** l'épaisseur de la première couche (2) est suffisamment petite pour qu'elle soit élastiquement déformée par les deuxième et troisième couches (3B, 3A).

**9.** Procédé selon l'une quelconque des deux revendications précédentes 7 et 8, **caractérisé en ce que** les deux matériaux de la première couche (2) et de la troisième couche (3A) respectives sont choisis de façon qu'il y ait des moyens pour retirer sélectivement une substance avec une capacité pour attaquer la première couche (2) devant être retirée significativement supérieure à la capacité pour attaquer la troisième couche (3A), la troisième couche (3A) formant ainsi une couche d'arrêt du retrait de la première couche (2), et **en ce que** le procédé comprend la mise en oeuvre d'un tel retrait sélectif de substance.

10. Procédé selon l'une quelconque des revendications 7 à 9, **caractérisé en ce que** la structure multicouche comprend plusieurs triplets, composés chacun desdites troisième couche (3A), première couche (2) et deuxième couche (3B), l'une de ces couches étant éventuellement retirée sélectivement par rapport à la couche formant une partie du même triplet et sous celle-ci, par des moyens capables de retirer sélectivement la substance.

11. Procédé selon l'une quelconque des revendications 5, 6, 9 et 10, **caractérisé en ce que** le retrait sélectif de substance comprend un décapage chimique sélectif.

12. Procédé selon la revendication 11, **caractérisé en ce que** la sélectivité du décapage chimique entre les deux matériaux considérés est obtenue par le fait que :

- les deux matériaux sont différents ; ou
- les deux matériaux contiennent des éléments atomiques presque identiques, à l'exception d'au moins un élément atomique ; ou
- les deux matériaux sont presque identiques, mais la concentration atomique d'au moins un élément atomique dans un matériau est significativement différente de la concentration atomique du même élément atomique dans l'autre matériau ; ou
- les deux matériaux ont des densités de porosité différentes.

13. Procédé selon la revendication 12, **caractérisé en ce que** la sélectivité de décapage entre les deux matériaux considérés est obtenue par le fait que les deux matériaux contiennent des éléments atomiques presque identiques, à l'exception d'au moins un élément atomique additionnel localisé dans la première couche, et dans lequel l'élément atomique additionnel est un élément dopant.

14. Procédé selon l'une quelconque des revendications 11, 12 et 13, dans lequel une attaque mécanique du matériau devant être retiré est réalisée en combinaison avec le décapage chimique sélectif, si bien qu'une planarisation mécanique-chimique sélective est utilisée.

15. Procédé selon l'une quelconque des revendications 5, 6, 9 et 10, **caractérisé en ce que** le retrait sélectif de substance comprend une attaque mécanique sélective.

16. Procédé selon la revendication 15, **caractérisé en ce que** l'attaque mécanique sélective est effectuée par polissage, éventuellement associé à un décapage par un abrasif et / ou chimique.

17. Procédé selon l'une quelconque des revendications 5, 6, 9 et 10, **caractérisé en ce que** le retrait sélectif de substance comprend le retrait d'une couche d'oxyde par une étape de désoxydation, la couche d'oxyde étant donc sacrificielle.

18. Procédé selon la revendication 17, **caractérisé en ce qu'**il comprend en outre une oxydation en surface de la structure multicouche (I) pour former la couche d'oxyde sacrificielle.

19. Procédé selon la revendication 18, **caractérisé en ce que** le procédé d'oxydation en surface est utilisé de façon qu'il soit plus facile d'oxyder la couche de surface que la couche sous celle-ci.

20. Procédé selon la revendication 1, **caractérisé en ce que** le substrat (1) comprend un substrat de support et une couche tampon, la couche tampon étant localisée entre le substrat de support et la structure multicouche (I), la couche tampon étant en un matériau cristallin ayant une composition chimique constante et une inégalité des paramètres de maille avec le substrat de support, confinant les défauts cristallographiques.

21. Procédé selon la revendication 20, **caractérisé en ce que** la couche tampon est en Si, SiGe, Ge ou un matériau de type nitrure, et **en ce que** la structure multicouche (I) comprend au moins l'un des matériaux suivants : Si élastiquement déformé, ou SiGe ou Ge.

22. Procédé selon l'une quelconque des revendications 1 à 19, **caractérisé en ce que** le substrat (1) comprend un substrat de support et une structure tampon avec un paramètre de réseau variant significativement et progressivement sur son épaisseur entre le paramètre de réseau du substrat de support et un autre paramètre de réseau significativement différent du paramètre de réseau du substrat de support.

23. Procédé selon la revendication 22, **caractérisé en ce que** la structure tampon comprend aussi une couche additionnelle sur la couche tampon, qui :

- est suffisamment épaisse pour confiner les défauts ; et / ou
- a un paramètre de réseau de surface légèrement différent du paramètre de réseau du substrat de support.

**24.** Procédé selon l'une des revendications 21, 22 et 23, **caractérisé en ce que** la structure tampon et la structure multicouche (I) comprennent toutes deux un alliage atomique appartenant à l'une des familles suivantes d'alliages atomiques :

> famille IV-IV ;
> famille III-V ;
> famille II-VI ;
> cet alliage étant de type binaire, ternaire, quaternaire ou de degré supérieur.

**25.** Procédé selon l'une des revendications 1 à 19, **caractérisé en ce que** le substrat (1) comprend :

> - dans une première configuration :
>
>> - un substrat de support en Si ;
>> - une structure tampon comprenant une couche tampon en SiGe ayant une concentration de Ge augmentant progressivement avec l'épaisseur et une couche additionnelle en SiGe relaxée par la couche tampon ;
>> - une structure multicouche (I) comprenant, avant enlèvement, du SiGe et / ou du Si élastiquement contraint ; ou
>
> - dans une deuxième configuration :
>
>> - un substrat de support en Si ;
>> - une structure tampon comprenant une couche tampon en SiGe ayant une concentration de Ge augmentant progressivement avec l'épaisseur et une couche additionnelle en SiGe relaxée par la couche tampon ;
>> - les mêmes couches et les mêmes matériaux que dans la première configuration, la couche tampon ayant une concentration de Ge augmentant avec l'épaisseur entre environ 0 % et environ 100 % et la couche additionnelle en SiGe relaxée par la couche tampon ayant une concentration de Si pratiquement de zéro ;
>> - comprenant, avant enlèvement, de l'AsGa et / ou du Ge ; ou
>
> - dans une troisième configuration :
> du Si au moins dans une partie épaisse formant une interface avec la structure multicouche (I) ;
>
>> - comprenant du SiGe et / ou du Si élastiquement contraint ; ou
>
> - dans une quatrième configuration :

> - un substrat de support comprenant de l'As-Ga à son interface avec la structure tampon ;
> - une structure tampon comprenant une couche tampon comprenant un alliage atomique appartenant à la famille III-IV du type ternaire ou d'un degré supérieur, dont la composition est choisie parmi les combinaisons possibles de (Al, Ga, In) - (N, P, As) et au moins deux éléments choisis dans la famille III ou au moins deux éléments choisis parmi la famille V, ces deux éléments ayant une concentration variant graduellement à l'intérieur de l'épaisseur de la couche tampon ;
> - une multicouche comprenant, avant enlèvement, un alliage appartenant à la famille III-V ; ou
>
> - dans une cinquième configuration : les mêmes couches et les mêmes matériaux que dans la quatrième configuration, sauf que :
>
>> - la structure tampon a aussi un paramètre de réseau similaire au paramètre de réseau d'InP près de la face opposée à son interface avec le substrat de support ; et
>> - la multicouche comprend, avant enlèvement, de l'InP et / ou de l'InGaAs ; ou
>
> - dans une sixième configuration :
>
>> - un substrat de support en saphir ou SiC ou Si ;
>> - une couche tampon en AlxGal-xN, où x varie dans l'épaisseur de 0 à 1 en partant de l'interface avec le substrat de support ;
>> - éventuellement une couche additionnelle de GaN, si elle existe ;
>> - une multicouche comprenant, avant enlèvement, de l'AlN, de l'InN et du GaN ; ou
>
> - dans une septième configuration :
>
>> - un substrat de support en saphir ou SiC ou Si ;
>> - éventuellement une couche de GaN ;
>> - un masque ;
>> - une couche tampon en GaN ;
>> - une multicouche comprenant, avant enlèvement, du GaN et éventuellement d'autres nitrures.

**26.** Procédé selon l'une des revendications 3 à 19 en combinaison avec la revendication 25, **caractérisé en ce que** la structure multicouche (I) comprend :

> - dans la première configuration :

- deux couches en SiGe presque relaxé élastiquement ; et
- une couche intermédiaire entre les deux couches en SiGe, composée de :
- Si élastiquement déformé pour avoir un paramètre de réseau similaire au paramètre de réseau des zones en SiGe adjacentes ; ou
- SiGe avec une concentration de Ge significativement différente des concentrations de Ge dans chacune des deux couches adjacentes, et étant élastiquement déformé pour avoir un paramètre de réseau similaire au paramètre de réseau des zones adjacentes ; ou
- Si dopé ou SiGe dopé ;

au moins l'une de ces trois couches étant une couche d'arrêt pour le décapage chimique sélectif de la couche la recouvrant ; ou

- dans la deuxième configuration :

  - deux couches en GaAs ;
  - une couche en AlGaAs intermédiaire entre les deux couches en GaAs ;
  au moins l'une de ces trois couches étant une couche d'arrêt pour le décapage chimique sélectif de la couche la recouvrant ; ou

- dans la troisième configuration :

  - deux couches en Si presque relaxé élastiquement ; et
  - une couche intermédiaire entre les deux couches en Si, composée de :
  - SiGe élastiquement déformé pour avoir un paramètre de réseau similaire au paramètre de réseau des zones de Si adjacentes ; ou
  - Si dopé ou SiGe dopé ;
  au moins l'une de ces trois couches étant une couche d'arrêt pour le décapage chimique sélectif de la couche la recouvrant ; ou

- dans la cinquième configuration :

  - deux couches en InP ;
  - une couche intermédiaire en InGaAsP entre les deux couches en InP ;
  au moins l'une de ces trois couches étant une couche d'arrêt pour le décapage chimique sélectif de la couche la recouvrant ;

- dans la sixième configuration :

  - une couche intermédiaire en InN entre une couche en AIN et une couche en GaN ;

- dans la septième configuration :

  - une couche intermédiaire en InN entre deux couches en GaN.

27. Procédé selon l'une quelconque des revendications précédentes, **caractérisé en ce qu'**une étape de finition de la surface de la tranche donneuse (10) est effectuée avant ou après retrait de substance.

28. Procédé selon l'une quelconque des revendications précédentes, dans lequel la tranche donneuse (10) comprend au moins une couche comprenant en outre du carbone avec une concentration de carbone dans la couche significativement inférieure ou égale à 50 %.

29. Procédé selon l'une quelconque des revendications précédentes, dans lequel la tranche donneuse (10) comprend au moins une couche comprenant en outre du carbone avec une concentration de carbone dans la couche significativement inférieure ou égale à 5 %.

30. Procédé selon l'une des revendications 1 à 29, **caractérisé en ce qu'**il comprend :

    (a) le collage de la tranche donneuse (10) avec un substrat récepteur (5) sur le côté de la couche utile devant être enlevée ;
    (b) le détachement de la couche utile incorporée dans la structure multicouche (I) de la tranche donneuse (10).

31. Procédé selon l'une des revendications 5 à 21 en combinaison avec la revendication 30, **caractérisé en ce que** la structure multicouche (I) de la tranche donneuse (10) comprend une couche d'arrêt pour le retrait de substance de la couche qui la recouvre, et **en ce que** l'étape (b) de détachement concerne une partie de la structure multicouche recouvrant la couche d'arrêt.

32. Procédé selon la revendication 30 ou 31, **caractérisé en ce qu'**il comprend la formation d'une couche de collage avant l'étape (a).

33. Procédé selon l'une quelconque des revendications 30, 31 et 32, **caractérisé en ce que :**

    - avant l'étape (a), il comprend la formation d'une fragilisation sous la couche utile, et **en ce que** :
    - l'étape (b) est mise en oeuvre par apport d'énergie dans la zone de fragilisation pour détacher de la tranche donneuse (10) une structure comprenant la couche utile.

34. Procédé selon la revendication 33, **caractérisé en ce que** la zone de fragilisation est formée par implantation d'espèces atomiques.

**35.** Procédé selon la revendication 34 précédente, **caractérisé en ce que** les espèces atomiques implantées comprennent au moins une proportion d'hydrogène et / ou d'hélium.

**36.** Procédé selon la revendication 34, **caractérisé en ce que** la zone de fragilisation est formée par porosification d'une couche.

**37.** Procédé selon l'une des revendications 30 à 36, **caractérisé en ce qu'**il comprend une autre étape, après l'étape (b), de finition de la surface de la couche utile au niveau de laquelle a eu lieu le détachement.

**38.** Procédé selon l'une des revendications 30 à 37, **caractérisé en ce que** la couche utile contient au moins l'un des matériaux suivants :

> SiGe, Si, un alliage appartenant à la famille III - V avec une composition choisie parmi les combinaisons possibles de (Al, Ga, In) - (N, P, As).

**39.** Procédé selon l'une des revendications 30 à 37, **caractérisé en ce que** la couche utile est au moins une partie d'une couche semi-conductrice d'une structure de semi-conducteur sur isolant.

**40.** Procédé selon l'une des revendications 30 à 39, **caractérisé en ce que** les étapes d'enlèvement d'une couche utile et de recyclage de la tranche donneuse (10) sont effectuées de manière itérative tour à tour.

FIG_1a

FIG_1b

FIG_1c

FIG_1d

...

FIG. 2a

FIG. 2b

FIG. 2c

FIG. 2d

10

3B
2B
I
3A
2A

1

## FIG.3

10

3D
2C
3C
2B
I
3B
2A
3A

## FIG.4

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0015885 A
- US 6500732 B
- FR 2775121
- EP 0849788 A
- EP 0849788 A2
- WO 9953539 A

### Non-patent literature cited in the description

- **L. J. HUANG et al.** SiGe-On-Insulator prepared by wafer bonding and layer transfer for high performance field-effect transistors. *Applied Physics Letters,* 26 February 2001, vol. 78 (9
- **B. HÖLLANDER et al.** Strain relaxation of pseudomorphic Si1-xGex / Si(100) heterostructures after hydrogen or helium ion implantation for virtual substrate fabrication. *Nuclear and Instruments and Methods in Physics Research B,* 2001, vol. 175-177, 357-367
- **SHUJI NAKAMURA.** InGaN/GaN/AlGaN-Based Laser Diodes with an Estimated Lifetime of Longer than 10 000 hours. *Materials Research Community,* May 1998, vol. 23 (5
- Semiconductor Wafer Bonding. **Q.Y. TONG ; U. GÖSELE ; WILEY.** Science and technology. Interscience Technology
- Strain relaxation of pseudomorphic Si1-xGex / Si(100) heterostructures after hydrogen or helium ion implantation for virtual substrate fabrication. *Nuclear and Instruments and methods in Physics Research B,* 2001, vol. 175-177, 357-367
- **R.T. LEONARD et al.** Photo-assisted dry etching of GaN. *Applied Physics letters,* 05 February 1996, vol. 68 (6
- **S.J. PEARTON et al.** Law Bias Electron Cyclotron Resonance Plasma Etching of GaN, AlN and InN. *Applied Physics Letters,* 25 April 1994, vol. 64 (17
- **SHUJI NAKAMURA.** In/GaN/AlGaN-Based Laser Diodes with an Estimated Lifetime of Longer than 10,000 Hours. *MRS Bulletin,* May 1998, vol. 23 (5